# EUROPEAN PATENT APPLICATION

(11) **EP 2 192 631 A1**
(43) Date of publication of application: **02.06.2010**
(21) Application number: 08830424.1
(22) Date of filing: 09.09.2008
(51) Int. Cl.: H01L 51/30, C09B 47/24, H01L 21/336, H01L 29/786, H01L 51/05, H01L 51/40

(54) **PROCESS FOR PRODUCTION OF DESUBSTITUTED COMPOUNDS, ORGANIC SEMICONDUCTOR FILM AND PROCESS FOR PRODUCTION OF THE FILM**

(30) Priority: 12.09.2007 JP 2007237313; 12.09.2007 JP 2007237315
(71) Applicant: Fujifilm Corporation, Tokyo 106-8620 (JP)
(72) Inventor: TAKAHASHI, Keita, Ashigarakami-gun Kanagawa 258-8577 (JP); KITAMURA, Tetsu, Ashigarakami-gun Kanagawa 258-8577 (JP); WATANABE, Tetsuya, Minami-ashigara-shi Kanagawa 250-0193 (JP)
(74) Representative: HOFFMANN EITLE
(86) International application number: PCT/JP2008/066252
(87) International publication number: WO 2009/034971

(57) **Abstract**

A method of producing a desubstituted compound, including: applying an external stimulation to a compound A-(B)ₘ having a solvent-soluble group B (wherein A represents a residue of a solvent-insoluble compound, B represents a specific solvent-soluble group, and m represents a natural number, and the solvent-soluble group B bonds to a carbon atom of the residue A of a solvent-insoluble compound), to cause desubstitution of the solvent-soluble group B, and converting the compound to a solvent-insoluble compound to which a hydrogen atom bonds in place of the solvent-soluble group B; a method of producing an organic semiconductor film, including: forming a film of a π-conjugated compound having a substituent represented by formula (2-1), on a substrate; and causing desubstitution of the substituent from the compound; and an organic semiconductor film and an organic electronic device each obtained by these methods: 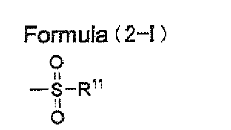 wherein R¹¹ represents a substituent other than a hydrogen atom.

## Description

### TECHNICAL FIELD

The present invention relates to a method of producing a desubstituted compound that is obtained by causing desubstitution of a specific substituent, and also relates to a method of producing pigment fine-particles, a method of producing a phthalocyanine compound, and a method of producing a thin film, each of which method is to utilize the desubstitution technique.

Further, the present invention relates to an organic semiconductor film and a method of producing the same, and also relates to a method of producing an organic semiconductor film by using a π-conjugated compound having a particular substituent.

### BACKGROUND ART

Coloring materials that are used for inks, coatings, resins or the like are roughly classified into dyes and pigments. For example, with respect to a colorant for an inkjet recording liquid (ink) that is required to have high definition, an image formed with an ink in which a dye is used has characteristics, such as high transparency, high definition, excellent color rendering properties or the like. On the other hand, the dye image is fraught with problems, such as weather resistance, water resistance or the like.

In recent years, in order to address such problems of both weather resistance and water resistance of images, the transition has begun from dye-based inks to inks using pigments such as organic pigments or carbon black. Further, hitherto, pigments have been studied focusing on their physical properties for coloring materials. In recent years, attention has been drawn to molecular properties of pigments (see, for example, "Technology of Functional Pigments and Development of their Application", CMC).

Amid such a transition of studies to pigments, as one of problems causing obstacles, it is pointed out that pigments generally have poor solubilities to solvents, e.g. water and organic solvents. For example, a dispersion of a pigment becomes unstable, arising from aggregation of the pigment that is occurred in an ink. Consequently, there are many problems on reliability from the viewpoint of, for example, ink ejection.

In order to cope with that, a method is proposed to cause desubstitution, by applying an external stimulation to a precursor having introduced therein a reactive substituent capable of making an organic material soluble (see, for example, Nature, Vol. 388 (1997), p.131, and JP-A-7-188234 ("JP-A" means unexamined published Japanese patent application)). In that method, for example, a pigment precursor of a structure of a pigment molecule in which an amino group or an alcoholic or phenolic hydroxyl group is modified with a t-butoxycarbonyl group (Boc group), is heated or subjected to other treatment, thereby causing desubstitution of the Boc group.

In that method, however, it is necessary that the substituent be linked to a nitrogen atom or an oxygen atom, and there is a limitation in compounds to be used in that method. In addition, improvements have been also required from the viewpoint of storage stability of the precursor.

Further, recently, the following method has been investigated strenuously in which an external stimulation is applied to a precursor having a high solubility to a solvent, to convert the precursor to porphyrin or phthalocyanine, according to a retro Diels-Alder reaction (see, for example, Applied Physics Letters, 2004, Vol. 84, p. 2085; JP-A-2006-165533, JP-A-2006-131574, JP-A-2005-93990, JP-A-2004-256450, JP-A-2004-6750, JP-A-2003-304014, JP-A-2006-182989, JP-A-2006-249436, JP-A-2004-320007, JP-A-2004-319982, JP-A-2005-79203, JP-A-2005-294809, JP-A-2005-277029, and JP-A-2005-79204).

However, those methods herein exemplified need improvement in storage stability of a precursor and a compound that is obtained by treating the precursor. Further, those methods each need complicated synthesis, and the range of application is narrow. Thus, it has been needed to develop a substituent with which synthesis can be carried out in a simpler manner.

Meanwhile, devices using organic semiconductor materials have been actively studied in recent years, since those devices can be produced by processes simpler than those of the conventional devices using inorganic semiconductor materials such as silicon, and since those devices are able to have a variety of organic semiconductor materials which is based on that characteristics of the materials can be easily modified by changing molecular structures of the materials. Thus, it is expected that both of functions and devices, each of which are not likely to be achieved by using the inorganic semiconductor materials, may be realized by using the organic semiconductor materials. Particularly, organic semiconductor materials capable of producing devices via a process including coating a solution on a substrate, namely a "solution process", are tremendously expected, since low-cost production and large-area making are readily achieved (Chemical Reviews, 107, 1296-1323 (2007)).

Organic semiconductor materials are roughly classified into high molecular materials and low molecular materials.

The high molecular material represented by a polythiophene derivative P3HT (poly(3-hexylthiophene)) is excellent in both of a solubility to a solvent (resolvability) and a coating property to form a film. However, any high molecular material more than satisfactory from the viewpoints of properties and stability has not found yet, for the following reasons: that it is difficult to produce a high molecular material at a high purity; that a molecular weight of the high molecular material results to have a distribution; and that a structural defect in a film arisen from incomplete portions in terms of stereoregularity of the molecular structure and the like, becomes a factor to limit the property of the resultant film.

In contrast, to the low molecular material represented by pentacene, oligothiophene, phthalocyanine and the like, various methods of purification, such as purification by sublimation, recrystallization, and column chromatography, can be applied, and it is possible to produce a high-purity low molecular material. Further, the low molecular material is stable in molecular structure, and the low molecular material is apt to form well-ordered crystalline structure. Resultantly, many low molecular materials showing high-level properties are known.

However, it is general that, among the low molecular materials hitherto reported, those showing relatively good properties are poor in solubilities to solvents, and consequently the way to carry out film formation of the low molecular materials are associated with a vacuum process high in production costs (film formation under a vacuum condition). For example, when film formation is carried out by a vacuum deposition method, the resultant film of pentacene is quite high in a carrier mobility and an on/off ratio, which outperform amorphous silicon. However, pentacene is low in solubilities to general-purpose solvents, and pentacene is not suitable for film formation according to a so-called solution process. Among the low molecular materials hitherto found out, a very limited number of organic semiconductor materials show relatively good semiconductor properties and are able to carry out film formation according to a solution process.

Meanwhile, it is known to introduce a substituent such as an alkyl group into an organic semiconductor skeleton, in order to improve a solubility to a solvent of the organic semiconductor material. However, introduction of the substituent often inhibits alignment and packing among the molecules, which result in deterioration of the semiconductor property.

In order to address these problems and to achieve the solution-process suitability and the semiconductor property at the same time, a method is reported in which a field-effect transistor is produced by the steps of: forming a film of a precursor of pentacene or porphyrin, each of which is high in a solubility to a solvent, via a solution process; and then applying an external stimulation, such as heating, to the resultant film, thereby converting the precursor to a semiconductor (Advanced Materials, 11, 480-483 (1999), JP-A-2003-304014). However, with respect to those examples, further improvement is required from the viewpoints of chemical stability and movement stability of a semiconductor precursor and a semiconductor that is obtained by treating the semiconductor precursor.

### DISCLOSURE OF INVENTION

As a result of intensive studies so as to address the above-described problems, the present inventors have found that, by using, as a precursor, a compound having a particular substituent different from a Boc group hitherto used, a solubility thereof is favorable, and a desubstitution reaction to release the substituent can be underwent rapidly by applying an external stimulation such as heat to the precursor, and storage stabilities of a reactant and a product are high, and crystalline structures of the product can be controlled, if necessary.

Further, the present inventors have found that, by using, as a precursor of an organic semiconductor, a π-conjugated compound having a particular substituent different from a conventional one, film formation on a substrate is readily carried out, and a desubstitution reaction to release the substituent can be underwent efficiently by applying an external stimulation, such as heat, to the thus-formed film, and it is possible to obtain an organic semiconductor film showing favorable semiconductor properties, such as high chemical stability and movement stability of the semiconductor.

The present invention has been attained based on those findings.

According to the present invention, there is provided the following means:
(1) A method of producing a desubstituted compound, comprising:
   applying an external stimulation to a compound A-(B)ₘ which has a solvent-soluble group B, to cause desubstitution of the solvent-soluble group B from the compound, wherein A represents a residue of a solvent-insoluble compound, the solvent-soluble group B is represented by formula (I), and m represents a natural number, in which the solvent-soluble group B bonds to a carbon atom of the residue A of a solvent-insoluble compound; and
   converting the compound A-(B)ₘ to a solvent-insoluble compound to which a hydrogen atom bonds in place of the solvent-soluble group B:

      Formula (I) -S(O)n-X
   wherein X represents a hydrogen atom or a substituent; and n represents an integer of 1 or 2.
(2) The method of producing a desubstituted compound as described in the item (1), wherein the external stimulation is conducted by heating at 150 to 500 °C.
(3) The method of producing a desubstituted compound as described in the item (1) or (2), wherein the residue A of a solvent-insoluble compound is a residue of a π-conjugated compound having a structure in which two or more aromatic hydrocarbon rings or aromatic hetero rings are condensed and/or linked via a covalent bond.
(4) The method of producing a desubstituted compound as described in any one of the items (1) to (3), wherein the residue A of a solvent-insoluble compound is a dye skeleton.
(5) The method of producing a desubstituted compound as described in any one of the items (1) to (4), wherein the solvent-soluble group B is a group represented by formula (II): 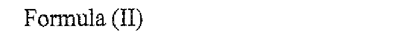 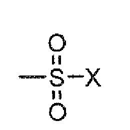 wherein X represents a hydrogen atom or a substituent.
(6) The method of producing a desubstituted compound as described in any one of the items (1) to (5), wherein the solvent-soluble group B is a group represented by formula (III): 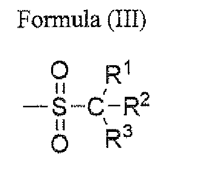 wherein R¹ to R³ each independently represent a hydrogen atom or a substituent.
(7) The method of producing a desubstituted compound as described in any one of the items (1) to (6), wherein the compound A-(B)ₘ is a compound represented by formula (IV): 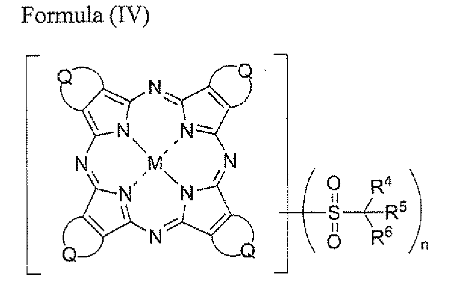 wherein M represents a metal atom or hydrogen atoms; when M represents hydrogen atoms, two hydrogen atoms bond to any two nitrogen atoms of N¹ to N⁴, separately; Q represents a group of atoms necessary to form an aromatic hydrocarbon ring or an aromatic hetero ring; a plurality of Qs may be the same or different from each other; R⁴ to R⁶ each independently represents a hydrogen atom or a substituent; n is a natural number; and when n is 2 or more, a plurality of the -SO₂C(R⁴)(R⁵)(R⁶) groups may be the same or different from each other.
(8) The method of producing a desubstituted compound as described in the item (7), wherein the compound A-(B)ₘ is a phthalocyanine compound.
(9) A method of producing pigment fine-particles, comprising:
   applying an external stimulation to a pigment precursor A-(B)ₘ of a structure in which a pigment is modified with a solvent-soluble group B, to cause desubstitution of the solvent-soluble group B from the pigment precursor, wherein A represents a residue of a pigment, the solvent-soluble group B is represented by formula (I), and m represents a natural number, in which the solvent-soluble group B bonds to a carbon atom of the residue A of a pigment; and
   converting the pigment precursor to a pigment to which a hydrogen atom bonds in place of the solvent-soluble group B:

      Formula (I) -S(O)n-X
   wherein X represents a hydrogen atom or a substituent; and n represents an integer of 1 or 2.
(10) A method of producing a phthalocyanine compound, comprising:
   applying an external stimulation to a phthalocyanine compound having a substituent represented by formula (I), thereby causing desubstitution of the substituent from the phthalocyanine compound, wherein the substituent binds to a carbon atom of a residue of the phthalocyanine compound; and
   converting the phthalocyanine compound having the substituent to a phthalocyanine compound to which a hydrogen atom bonds in place of the substituent:

      Formula (I) -S(O)n-X
   wherein X represents a hydrogen atom or a substituent; and n represents an integer of 1 or 2.
(11) A method of producing a thin film, comprising:
   dissolving a compound A-(B)ₘ which has a solvent-soluble group B, in a solvent, to give a solution, wherein A represents a residue of a solvent-insoluble compound, the solvent-soluble group B is represented by formula (I), and m represents a natural number, in which the solvent-soluble group B bonds to a carbon atom of the residue A of a solvent-insoluble compound;
   coating a substrate with the solution, to form a coated film;
   applying an external stimulation to the compound A-(B)ₘ in the coated film, to cause desubstitution of the solvent-soluble group B from the compound; and
   converting the compound A-(B)ₘ to a solvent-insoluble compound to which a hydrogen atom bonds in place of the solvent-soluble group B, thereby forming a thin film of the solvent-insoluble compound:

      Formula (I) -S(O)n-X

      wherein X represents a hydrogen atom or a substituent; and n represents an integer of 1 or 2.
<12> A method of producing an organic semiconductor film, comprising the steps of:
   forming a film of a π-conjugated compound having a substituent represented by formula (2-1), on a substrate; and
   causing desubstitution of the substituent from the compound: 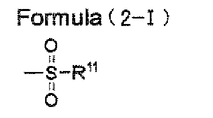 wherein R¹¹ represents a substituent other than a hydrogen atom.
<13> The method of producing an organic semiconductor film as described in the item <12>, wherein the compound is a compound represented by formula (2-II): 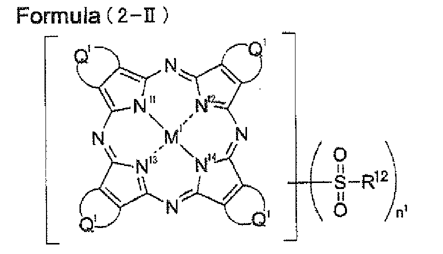 wherein M¹ represents a metal atom or hydrogen atoms; when M¹ represents hydrogen atoms, two hydrogen atoms bond to any two nitrogen atoms of N¹¹ to N¹⁴, separately; Q¹ represents a group of atoms necessary to form an aromatic hydrocarbon ring or an aromatic hetero ring; a plurality of Q¹s may be the same or different from each other; R¹² represents a substituent other than a hydrogen atom; n¹ is a natural number; and when n¹ is 2 or more, a plurality of the -SO₂R¹² groups may be the same or different from each other.
<14> The method of producing an organic semiconductor film as described in the item <13>, wherein the compound is a phthalocyanine compound.
<15> The method of producing an organic semiconductor film as described in any one of the items <12> to <14>, wherein the step of forming the film of the compound on the substrate is a step of forming the film, by dissolving the compound in a solvent, to give a solution, coating the substrate with the solution, and drying.
<16> The method of producing an organic semiconductor film as described in any one of the items <12> to <15>, wherein the step of causing desubstitution of the substituent is conducted by heating.
<17> An organic semiconductor film obtained by the method as described in any one of the items <12> to <16>.
<18> An organic electronic device, comprising the organic semiconductor film as described in the item <17>.
<19> An organic field-effect transistor, comprising the organic semiconductor film as described in the item <17>.
<20> An organic photoelectric conversion device, comprising the organic semiconductor film as described in the item <17>.

Hereinafter, a first embodiment of the present invention means to include the methods of producing a desubstituted compound as described in the items (1) to (8) above, the method of producing pigment fine-particles as described in the item (9) above, the method of producing a phthalocyanine compound as described in the item (10) above, and the method of producing a thin film as described in the item (11) above.

Further, a second embodiment of the present invention means to include the methods of producing an organic semiconductor film as described in the items <12> to <16> above, the organic semiconductor film as described in the item <17> above, the organic electronic device as described in the item <18> above, the organic field-effect transistor as described in the item <19> above, and the organic photoelectric conversion device as described in the item <20> above.

Herein, the present invention means to include all of the above first and second embodiments, unless otherwise specified.

Other and further features and advantages of the invention will appear more fully from the following description, appropriately referring to the accompanying drawings.

### BRIEF DESCRIPTION OF THE DRAWINGS

Fig. 1 is a graph showing the results of TG/DTA measurement of Exemplified Compound (1) (Compound 1a).
Figs. 2(a) and 2(b) are graphs showing the results of MALDI-TOF-MS spectrum measurement of Exemplified compound (1). Figs. 2(a) and 2(b) show the results before and after heat treatment, respectively.
Figs. 3(a), 3(b) and 3(c) are graphs showing the results of X-ray diffraction measurement of Exemplified compound (1). Fig. 3(a) shows the results before heat treatment and after heating at 350°C. Fig. 3(b) shows the results before heat treatment and after heating at 400 °C. Fig. 3(c) shows the results before heat treatment and after heat treatment at 550°C.
Fig. 4 is a graph showing the results of SC/DSC measurement of Exemplified Compound (1) (Compound 1a).
Fig. 5 is a graph showing the results of TG measurement of Exemplified compound (51) (Compound 1b).
Fig. 6 is a graph showing the results of TG measurement of Exemplified compound (52) (Compound 1c).
Fig. 7 is a graph showing the results of TG measurement of Exemplified compound (53) (Compound 7a).
Fig. 8 is a graph showing the results of TG measurement of Exemplified compound (54) (Compound 7b).
Fig. 9 is a graph showing the absorption spectra of the film composed of Exemplified compound (1). In the graph, the line indicated with "thin film 1 " is a spectrum before the heat treatment, and the line indicated with "thin film 2" is a spectrum after the heat treatment.
Fig. 10 is a graph showing the absorption spectra of the film composed of Compound 1 for comparison. In the graph, the line indicated with "thin film 3" is a spectrum before the heat treatment, and the line indicated with "thin film 4" is a spectrum after the heat treatment.
Fig. 11 is a graph showing the results of X-ray diffraction measurement of the crystal obtained in Comparative Example 2.
Fig. 12 is a graph showing the results of X-ray diffraction measurement of the α-type crystal obtained in Example 1, as compared to the results of the α-type crystal obtained in Comparative Example 2.
Fig. 13 is a graph showing the results of TG/DTA measurement of a commercially available copper phthalocyanine-tetrasulfonic acid tetrasodium salt.
Fig. 14 is a cross-sectional view schematically showing a structure of the top contact-type device of the organic field-effect transistor.
Fig. 15-1 is a cross-sectional view schematically showing a structure of the bottom contact-type device of the organic field-effect transistor.
Fig. 15-2 is a cross-sectional view schematically showing a structure of an organic photoelectric conversion device according to the second embodiment of the present invention.
Figs. 16(a) and 16(b) are graphs showing FET characteristics of a film composed of Compound 1a according to the second embodiment of the present invention. Figs. 16(a) and 16(b) show the FET characteristics before and after the heating treatment, respectively.
Fig. 17 is a graph showing absorption spectra of the film composed of Compound 1a before and after the heat treatment, respectively.

### BEST MODE FOR CARRYING OUT THE INVENTION

The present invention is described in detail below.

First, the first embodiment of the present invention is described in detail.

The method of producing a desubstituted compound according to the first embodiment of the present invention includes: a step of dissolving a specific compound in a solvent; and a step of causing desubstitution of the substituent from the compound. The specific compound is represented by A-(B)ₘ, wherein A represents a residue of (i.e. a group to give) a solvent-insoluble compound, B represents a solvent-soluble group represented by formula (I), and m re presents a natural number. Hereinafter, the compound having the solvent-soluble group B, namely A-(B)ₘ, is referred to as a "solvent-soluble precursor compound".

In the solvent-soluble precursor compound to be used in the production method according to the first embodiment of the present invention, the solvent-soluble group B bonds to a carbon atom in the residue A of a solvent-insoluble compound. Upon the step of desubstitution of solvent-soluble group B from the precursor compound, the solvent-soluble group B that had bonded to the carbon atom in the residue A of a solvent-insoluble compound is released to desubstitute from the precursor compound, to give a solvent-insoluble compound in which the solvent-soluble group B is substituted with a hydrogen atom, preferably to give a compound represented by A-(H)ₘ, wherein A represents the residue of a solvent-insoluble compound, H represents a hydrogen atom, and m represents a natural number.

The solvent-soluble precursor compound to be used in the first embodiment of the present invention has a structure, in which the solvent-soluble group B bonds to the residue A of a solvent-insoluble compound from which a hydrogen atom or the like that had bonded to an arbitrary carbon atom of the solvent-insoluble compound is removed. The solvent-soluble group B is represented by formula (I).

Formula (I) -S(O)n-X

In formula (I), X represents a hydrogen atom or a substituent; and n represents an integer of 1 or 2.

Examples of the substituent represented by X include a halogen atom, an alkyl group (including a cyclic structure, such as a cycloalkyl group and a bicycloalkyl group), an alkenyl group (including a cyclic structure, such as a cycloalkenyl group and a bicycloalkenyl group), an alkynyl group, an aryl group, a heterocyclic group, a cyano group, a hydroxyl group, a nitro group, a carboxyl group, an alkoxy group, an aryloxy group, a silyloxy group, a heterocyclic oxy group, an aryloxy group, a carbamoyloxy group, an alkoxycarbonyloxy group, an aryloxycarbonyloxy group, an amino group (including an anilino group), an acylamino group, an aminocarbonylamino group, an alkoxycarbonylamino group, an aryloxycarbonylamino group, a sulfamoylamino group, an alkyl- or aryl-sulfonylamino group, a mercapto group, an alkylthio group, an arylthio group, a heterocyclic thio group, a sulfamoyl group, a sulfo group, an alkyl- or aryl-sulfinyl group, an alkyl- or aryl-sulfonyl group, an acyl group, an aryloxycarbonyl group, an alkoxycarbonyl group, a carbamoyl group, an aryl- or heterocyclic-azo group, an imido group, a phosphino group, a phosphinyl group, a phosphinyloxy group, a phosphinylamino group, and a silyl group.

More specifically, examples of the substituent represented by X include: a halogen atom (e.g., a chlorine atom, a bromine atom, an iodine atom), an alkyl group [which represents a substituted or unsubstituted, linear, branched, or cyclic alkyl group, and which includes an alkyl group (preferably an alkyl group having 1 to 30 carbon atoms, e.g. methyl, ethyl, n-propyl, isopropyl, t-butyl, n-octyl, eicosyl, 2-chloroethyl, 2-cyanoethyl, and 2-ethylhexyl), a cycloalkyl group (preferably a substituted or unsubstituted cycloalkyl group having 3 to 30 carbon atoms, e.g. cyclohexyl, cyclopentyl, and 4-n-dodecylcyclohexyl), a bicycloalkyl group (preferably a substituted or unsubstituted bicycloalkyl group having 5 to 30 carbon atoms, i.e. a monovalent group obtained by removing one hydrogen atom from a bicycloalkane having 5 to 30 carbon atoms, e.g. bicyclo[1.2.2]heptan-2-yl and bicyclo[2.2.2]octan-3-yl), and a tricyclo or higher structure having three or more ring structures; and an alkyl group in substituents described below (e.g. an alkyl group in an alkylthio group) represents such an alkyl group of the above concept];
an alkenyl group [which represents a substituted or unsubstituted linear, branched, or cyclic alkenyl group, and which includes an alkenyl group (preferably a substituted or unsubstituted alkenyl group having 2 to 30 carbon atoms, e.g. vinyl, allyl, prenyl, geranyl, and oleyl), a cycloalkenyl group (preferably a substituted or unsubstituted cycloalkenyl group having 3 to 30 carbon atoms, i.e. a monovalent group obtained by removing one hydrogen atom from a cycloalkene having 3 to 30 carbon atoms, e.g. 2-cyclopenten-1-yl and 2-cyclohexen-1-yl), and a bicycloalkenyl group (which represents a substituted or unsubstituted bicycloalkenyl group, preferably a substituted or unsubstituted bicycloalkenyl group having 5 to 30 carbon atoms, i.e. a monovalent group obtained by removing one hydrogen atom from a bicycloalkene having one double bond, e.g. bicyclo[2.2.1]hept-2-en-1-yl and bicyclo[2.2.2]oct-2-en-4-yl)]: an alkynyl group (preferably a substituted or unsubstituted alkynyl group having 2 to 30 carbon atoms, e.g., ethynyl, propargyl, and trimethylsilylethynyl); an aryl group (preferably a substituted or unsubstituted aryl group having 6 to 30 carbon atoms, e.g. phenyl, p-tolyl, naphthyl, m-chlorophenyl, and o-hexadecanoylaminophenyl); a heterocyclic group (preferably a monovalent group obtained by removing one hydrogen atom from a substituted or unsubstituted 5- or 6-membered aromatic or nonaromatic heterocyclic compound; more preferably a 5- or 6-membered aromatic heterocyclic group having 3 to 30 carbon atoms, e.g. 2-furyl, 2-thienyl, 2-pyrimidinyl, and 2-benzothiazolyl); a cyano group; a hydroxyl group; a nitro group; a carboxyl group;
an alkoxy group (preferably a substituted or unsubstituted alkoxy group having 1 to 30 carbon atoms, e.g. methoxy, ethoxy, isopropoxy, t-butoxy, n-octyloxy, and 2-methoxyethoxy); an aryloxy group (preferably a substituted or unsubstituted aryloxy group having 6 to 30 carbon atoms, e.g. phenoxy, 2-methylphenoxy, 4-t-butylphenoxy, 3-nitrophenoxy, and 2-tetradecanoylaminophenoxy); a silyloxy group (preferably a silyloxy group having 3 to 20 carbon atoms, e.g. trimethylsilyloxy and t-butyldimethylsilyloxy); a heterocyclic oxy group (preferably a substituted or unsubstituted heterocyclic oxy group having 2 to 30 carbon atoms, e.g. 1-phenyltetrazol-5-oxy and 2-tetrahydropyranyloxy); an acyloxy group (preferably a formyloxy group, a substituted or unsubstituted alkylcarbonyloxy group having 2 to 30 carbon atoms, or a substituted or unsubstituted arylcarbonyloxy group having 6 to 30 carbon atoms, e.g. formyloxy, acetyloxy, pivaloyloxy, stearoyloxy, benzoyloxy, and p-methoxyphenylcarbonyloxy);
a carbamoyloxy group (preferably a substituted or unsubstituted carbamoyloxy group having 1 to 30 carbon atoms, e.g. N,N-dimethylcarbamoyloxy, N,N-diethylcarbamoyloxy, morpholinocarbonyloxy, N,N-di-n-octylaminocarbonyloxy, and N-n-octylcarbamoyloxy); an alkoxycarbonyloxy group (preferably a substituted or unsubstituted alkoxycarbonyloxy group having 2 to 30 carbon atoms, e.g. methoxycarbonyloxy group, ethoxycarbonyloxy group, t-butoxycarbonyloxy group, and n-octylcarbonyloxy group); an aryloxycarbonyloxy group (preferably a substituted or unsubstituted aryloxycarbonyloxy group having 7 to 30 carbon atoms, e.g. phenoxycarbonyloxy, p-methoxyphenoxycarbonyloxy, and p-n-hexadecyloxyphenoxycarbonyloxy);
an amino group (preferably an amino group, a substituted or unsubstituted alkylamino group having 1 to 30 carbon atoms, or a substituted or unsubstituted anilino group having 6 to 30 carbon atoms, e.g. amino, methylamino, dimethylamino, anilino, N-methyl-anilino, and diphenylamino); an acylamino group (preferably a formylamino group, a substituted or unsubstituted alkylcarbonylamino group having 1 to 30 carbon atoms, or a substituted or unsubstituted arylcarbonylamino group having 6 to 30 carbon atoms, e.g. formylamino, acetylamino, pivaloylamino, lauroylamino, benzoylamino, and 3,4,5-tri-n-octyloxyphenylcarbonylamino); an aminocarbonylamino group (preferably a substituted or unsubstituted aminocarbonylamino group having 1 to 30 carbon atoms, e.g. carbamoylamino, N,N-dimethylaminocarbonylamino, N,N-diethylaminocarbonylamino, and morpholinocarbonylamino);
an alkoxycarbonylamino group (preferably a substituted or unsubstituted alkoxycarbonylamino group having 2 to 30 carbon atoms, e.g. methoxycarbonylamino, ethoxycarbonylamino, t-butoxycarbonylamino, n-octadecyloxycarbonylamino, and N-methyl-methoxycarbonylamino); an aryloxycarbonylamino group (preferably a substituted or unsubstituted aryloxycarbonylamino group having 7 to 30 carbon atoms, e.g. phenoxycarbonylamino group, p-chlorophenoxycarbonylamino group, and m-(n-octyloxy)phenoxycarbonylamino group); a sulfamoylamino group (preferably a substituted or unsubstituted sulfamoylamino group having 0 to 30 carbon atoms, e.g. sulfamoylamino, N,N-dimethylaminosulfonylamino, and N-n-octylaminosulfonylamino);
an alkyl- or aryl-sulfonylamino group (preferably a substituted or unsubstituted alkylsulfonylamino group having 1 to 30 carbon atoms, or a substituted or unsubstituted arylsulfonylamino group having 6 to 30 carbon atoms, e.g. methylsulfonylamino, butylsulfonylamino, phenylsulfonylamino, 2,3,5-trichlorophenylsulfonylamino, and p-methylphenylsulfonylamino); a mercapto group; an alkylthio group (preferably a substituted or unsubstituted alkylthio group having 1 to 30 carbon atoms, e.g. methylthio, ethylthio, and n-hexadecylthio); an arylthio group (preferably a substituted or unsubstituted arylthio group having 6 to 30 carbon atoms, e.g. phenylthio, p-chlorophenylthio, and m-methoxyphenylthio); a heterocyclic thio group (preferably a substituted or unsubstituted heterocyclic thio group having 2 to 30 carbon atoms, e.g. 2-benzothiazolyl thio group and 1-phenyltetrazol-5-yl thio group);
a sulfamoyl group (preferably a substituted or unsubstituted sulfamoyl group having 0 to 30 carbon atoms, e.g. N-ethylsulfamoyl, N-(3-dodecyloxypropyl)sulfamoyl, N,N-dimethylsulfamoyl, N-acetylsulfamoyl, N-benzoylsulfamoyl, and N-(N'-phenylcarbamoyl)sulfamoyl); a sulfo group; an alkyl- or aryl-sulfinyl group (preferably a substituted or unsubstituted alkylsulfinyl group having 1 to 30 carbon atoms, or a substituted or unsubstituted arylsulfinyl group having 6 to 30 carbon atoms, e.g. methylsulfinyl, ethylsulfinyl, phenylsulfinyl, and p-methylphenylsulfinyl); an alkyl- or aryl-sulfonyl group (preferably a substituted or unsubstituted alkylsulfonyl group having 1 to 30 carbon atoms, or a substituted or unsubstituted arylsulfonyl group having 6 to 30 carbon atoms, e.g. methylsulfonyl, ethylsulfonyl, phenylsulfonyl, and p-methylphenylsulfonyl);
an acyl group (preferably a formyl group, a substituted or unsubstituted alkylcarbonyl group having 2 to 30 carbon atoms, a substituted or unsubstituted arylcarbonyl group having 7 to 30 carbon atoms, or a substituted or unsubstituted heterocyclic carbonyl group having 4 to 30 carbon atoms, which is bonded to said carbonyl group through a carbon atom, e.g. acetyl, pivaloyl, 2-chloroacetyl, stearoyl, benzoyl, p-n-octyloxyphenylcarbonyl, 2-pyridylcarbonyl, and 2-furylcarbonyl); an aryloxycarbonyl group (preferably a substituted or unsubstituted aryloxycarbonyl group having 7 to 30 carbon atoms, e.g. phenoxycarbonyl, o-chlorophenoxycarbonyl, m-nitrophenoxycarbonyl, and p-t-butylphenoxycarbonyl); an alkoxycarbonyl group (preferably a substituted or unsubstituted alkoxycarbonyl group having 2 to 30 carbon atoms, e.g. methoxycarbonyl, ethoxycarbonyl, t-butoxycarbonyl, and n-octadecyloxycarbonyl); a carbamoyl group (preferably a substituted or unsubstituted carbamoyl group having 1 to 30 carbon atoms, e.g. carbamoyl, N-methylcarbamoyl, N,N-dimethylcarbamoyl, N,N-di-n-octylcarbamoyl, and N-(methylsulfonyl)carbamoyl); an aryl- or heterocyclic-azo group (preferably a substituted or unsubstituted aryl azo group having 6 to 30 carbon atoms, or a substituted or unsubstituted heterocyclic azo group having 3 to 30 carbon atoms, e.g. phenylazo, p-chlorophenylazo, and 5-ethylthio-1,3,4-thiadiazol-2-yl azo); an imido group (preferably N-succinimido or N-phthalimido); a phosphino group (preferably a substituted or unsubstituted phosphino group having 2 to 30 carbon atoms, e.g. dimethylphosphino, diphenylphosphino, and methylphenoxyphosphino); a phosphinyl group (preferably a substituted or unsubstituted phosphinyl group having 2 to 30 carbon atoms, e.g. phosphinyl, dioctyloxyphosphinyl, and diethoxyphosphinyl); a phosphinyloxy group (preferably a substituted or unsubstituted phosphinyloxy group having 2 to 30 carbon atoms, e.g. diphenoxyphosphinyloxy and dioctyloxyphosphinyloxy); a phosphinylamino group (preferably a substituted or unsubstituted phosphinylamino group having 2 to 30 carbon atoms, e.g. dimethoxyphosphinylamino and dimethylaminophosphinylamino); a silyl group (preferably a substituted or unsubstituted silyl group having 3 to 30 carbon atoms, e.g. trimethylsilyl, t-butyldimethylsilyl, and phenyldimethylsilyl).

Among the substituents, with respect to one having a hydrogen atom, the hydrogen atom may be removed and be substituted by any of the above-mentioned substituents. Examples of such a substituent include: an alkylcarbonylaminosulfonyl group, an arylcarbonylaminosulfonyl group, an alkylsulfonylaminocarbonyl group, and an arylsulfonylaminocarbonyl group. Specific examples thereof include a methylsulfonylaminocarbonyl group, a p-methylphenylsulfonylaminocarbonyl group, an acetylaminosulfonyl group, and a benzoylaminosulfonyl group. Further, the substituent represented by X may be further substituted with a substituent.

In formula (I), n is preferably 2. The substituent represented by formula (I) is preferably a substituent represented by formula (II).

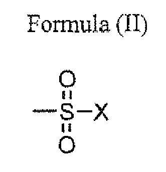

In formula (II), X has the same meanings as that of X in formula (I) described above, and preferable ranges thereof are also the same.

The substituent represented by formula (II) is preferably a substituent represented by formula (III).

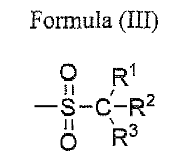

In formula (III), R¹ to R³ each independently represent a hydrogen atom or a substituent. It is preferable that two or more of R¹ to R³ are a substituent other than a hydrogen atom, and more preferably all of R¹ to R³ are a substituent other than a hydrogen atom.

Examples of the substituent represented by R¹ to R³ each independently include substituents recited as examples of the substituent represented by X. Further, R¹, R² and R³ may bind to each other to form a ring.

The substituents represented by R¹ to R³ each are preferably a halogen atom, a substituted or unsubstituted alkyl group having 1 to 30 carbon atoms, a substituted or unsubstituted aryl group having 6 to 30 carbon atoms, a 5- or 6-membered substituted or unsubstituted heterocyclic group, a cyano group, a substituted or unsubstituted alkoxy group having 1 to 30 carbon atoms, a substituted or unsubstituted alkylcarbonyl group having 2 to 30 carbon atoms, a substituted or unsubstituted arylcarbonyl group having 7 to 30 carbon atoms, a substituted or unsubstituted alkoxycarbonyl group having 2 to 30 carbon atoms, or a substituted or unsubstituted aryloxycarbonyloxy group having 7 to 30 carbon atoms; further preferably a halogen atom, an alkyl group having 1 to 30 carbon atoms, a cyano group, a substituted or unsubstituted alkylcarbonyl group having 2 to 30 carbon atoms, or a substituted or unsubstituted alkoxycarbonyl group having 2 to 30 carbon atoms; and most preferred being a case where each of R¹ to R³ is a methyl group.

There is no restriction in the number of the substituent represented by formula (I) present in the molecule. From the viewpoints of solubilities to solvents and film-forming properties, as the number of the substituent increases, greater advantages are obtained. On the other hand, from a viewpoint of uniformity of the thin film, it is preferable that a change in volume before and after desubstitution is as small as possible. Therefore, it is preferable that the number of the substituent represented by formula (I) present in the molecule is from 1 to 4. When plural numbers of the substituent represented by formula (I) are present in the molecule, they may be the same or different from each other.

The solvent-soluble precursor compound for use in the production method according to the first embodiment of the present invention has a solvent-soluble group as described above, and has a structure in which a solvent-soluble group bonds to a residue of the solvent-insoluble compound in which an arbitrary hydrogen atom of the water-insoluble compound has been removed. In the method of producing a desubstituted compound according to the first embodiment of the present invention, a solvent-soluble group is released to desubstitute from the precursor compound, to convert the solvent-soluble precursor compound into a solvent-insoluble compound.

In the first embodiment of the present invention, the term "solvent-soluble (being soluble in a solvent)" means to show a solubility of 0.1% by mass or more, more preferably 0.5% by mass or more, and further preferably 1% by mass or more, with respect to a solvent in interest when the solvent to which a compound in interest is added is heated under reflux and then cooled down to room temperature. Further, the term "solvent-insolubilization (to make a compound insoluble in a solvent)" means to reduce the solubility by one digit figure or more than the solvent-soluble state. Specifically, with respect to a solvent, when the solvent is heated under reflux and then cooled down to room temperature, it is preferable to reduce from the solubility of 0.1% by mass or more (solvent-soluble) to the solubility of 0.01% by mass or less, further preferably from the solubility of 0.5% by mass or more (solvent-soluble) to the solubility of 0.05% by mass or less, and especially preferably from the solubility of 1% by mass or more (solvent-soluble) to the solubility of less than 0.1 % by mass. Further, the term "solvent-insoluble (being insoluble in a solvent)" means to show solubility of less than 0.1% by mass, preferably 0.05% by mass or less, and further preferably 0.01% by mass or less, with respect to a solvent in interest when the solvent to which a compound in interest is added is heated under reflux and then cooled down to room temperature.

There is no particular restriction in the kind of solvent when degrees of the above-described "solvent-soluble" and "solvent-insoluble" are defined. Accordingly, both "solvent-soluble" and "solvent-insoluble" may be defined in terms of solvent and temperature each of which is actually used. Alternatively, for example, these properties may be specified as solubility (25°C) with respect to water (distilled water). However, the solvent used in the first embodiment of the present invention is not limited by the above.

A π-conjugated compound may be obtained by the production method according to the first embodiment of the present invention. Any compound may be used as the π-conjugated compound, so far as the compound has a broad π-conjugated plane. It is preferable that the π-conjugated compound has a structure in which any two or more of aromatic hydrocarbon rings and aromatic hetero rings {e.g. a benzene ring, a pyridine ring, a pyrazine ring, a pyrimidine ring, a triazine ring, a pyrrol ring, a pyrazole ring, an imidazole ring, a triazole ring, an oxazole ring, a thiazole ring, a furan ring, or a thiophene ring, and more preferably a benzene ring, a pyridine ring, a pyrazine ring, a pyrrol ring, a pyrazole ring, an imidazole ring, an oxazole ring, a thiazole ring, or a thiophene ring} are condensed, and/or linked by a covalent bond(s), and further π-electrons, which the aromatic hydrocarbon ring(s) and/or the aromatic hetero ring(s) each has, are delocalized over the entire condensed ring and/or linked rings by the interaction of ring condensation and/or linkage. The number of the aromatic hydrocarbon rings and/or the aromatic hetero rings that are condensed, and/or linked by a covalent bond(s) is preferably from 2 to 20, and more preferably from 3 to 12.

Specific examples of the π-conjugated compound include condensed-polycyclic compounds such as tetracene, pentacene, triphenylene, and hexabenzocoronene; hetero ring oligomers such as quarterthiophene, and sexithiophene; phthalocyanines; and porphyrins.

As the target solvent-insoluble compound obtained by the production method according to the first embodiment of the present invention, compounds usable as an UV absorbing agent can be mentioned. Examples of the compounds include triazine compounds, benzotriazole compounds and benzophenone compounds. Further, compounds usable as an organic pigment can be mentioned. There is no particular limitation in the kind of organic pigment, and examples of the organic pigment include azo pigments (for example, the insoluble azo pigment is roughly classified into insoluble monoazo pigments and insoluble disazo pigments; examples of the insoluble monoazo pigments include acetoacetic acid arylide-based, β-naphthol-based, naphthol AS-based, and benzimidazolone-based pigments; and examples of the insoluble bisazo pigments include acetoacetic acid arylide-based, pyrazolone-based, and condensed azo-based pigments; and further, the azo pigments include azo lake pigments), condensed polycyclic pigments (examples of these pigments include anthraquinone-based, isoindolinone-based, isoindoline-based, quinacridone-based, perylene-based, perinone-based, dioxazine-based, diketopyrrolopyrrol-based, indigo-based, and quinophthalone-based pigments), metal complex pigments (examples of these pigments include phthalocyanine-based, azomethine-based, and nitraso-based pigments) and other pigments (for example, azine-based pigments, daylight fluorescent pigments, carbon black).

In the first embodiment of the present invention, from viewpoint of chemical stability, the π-conjugated compound is preferably tetracene, pentacene, triphenylene, hexabenzocoronene; or porphyrins. Triazine compounds or benzotriazole compounds are preferable as an UV absorbing agent. Condensed-polycyclic pigments or metal complex pigments are preferable as an organic pigment. Among these, tetracene, pentacene, triphenylene, hexabenzocoronene, triazine-based compounds, condensed-polycyclic compounds or metal complex pigments are further preferable.

From the viewpoint of obtaining a target compound, as for the residue A of a solvent-insoluble compound in which a hydrogen atom that had bonded to an arbitrary carbon atom of the solvent-insoluble compound has been removed, a residue of a π-conjugated compound having a structure in which two or more aromatic hydrocarbon ring(s) and/or aromatic hetero ring(s) are condensed and/or are linked via a covalent bond(s) is preferable. Besides, as for the residue A of a solvent-insoluble compound, a dye skeleton is preferable. Further, as for the residue A of a solvent-insoluble compound, a residue of a pigment is preferable, and a residue of phthalocyanine is especially preferable.

The solvent-soluble precursor compound for use in the first embodiment of the present invention is more preferably a compound represented by formula (IV) from the viewpoint of chemical stability of the compound. It is especially preferable that the compound represented by formula (IV) is a phthalocyanine compound. Herein, the "phthalocyanine compound" means a compound having a phthalocyanine skeleton, and specifically a derivative of phthalocyanine wherein the phthalocyanine is substituted with a substituent.

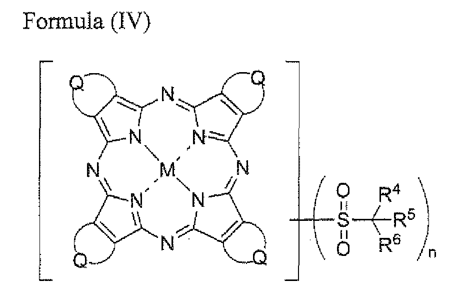

In formula (IV), Q represents a group of atoms necessary to form an aromatic hydrocarbon ring or an aromatic hetero ring. A plurality of Qs may be the same or different from each other. Herein, the aromatic hydrocarbon ring or the aromatic hetero ring is preferably a 4- to 10-membered ring, more preferably a 5- to 7-membered ring, further preferably a 5- or 6-membered ring, and especially preferably a 6-membered ring.

The hetero atom contained in the aromatic hetero ring formed by Q is not particularly limited, but nitrogen, oxygen, sulfur, selenium, silicon, germanium, or phosphorus is preferable. Among these atoms, nitrogen, oxygen, or sulfur is more preferable, and nitrogen is especially preferable. The number of hetero atoms contained in one aromatic hetero ring formed by Q is not particularly limited, but the number is preferably from 1 to 3.

Specific examples of the aromatic hydrocarbon ring or the aromatic hetero ring formed by Q include a benzene ring, a pyridine ring, a pyrazine ring, a pyrimidine ring, a pyridazine ring, a pyrrol ring, a pyrazole ring, an imidazole ring, a triazole ring, an oxazole ring, an oxadiazole ring, a thiazole ring, a thiadiazole ring, a furan ring, a thiophene ring, a selenophene ring, a silole ring, a germole ring, and a phosphole ring.

The aromatic hydrocarbon ring or the aromatic hetero ring formed by Q may have a substituent(s). As the substituent, those exemplified above with respect to R¹ to R³ may be applied.

The aromatic hydrocarbon ring or the aromatic hetero ring formed by Q may further form a condensed ring with other ring(s). Examples of the other ring taking part in formation of the condensed ring include: a benzene ring, a pyridine ring, a pyrazine ring, a pyrimidine ring, a pyridazine ring, a pyrrol ring, a pyrazole ring, an imidazole ring, a triazole ring, an oxazole ring, an oxadiazole ring, a thiazole ring, a thiadiazole ring, a furan ring, a thiophene ring, a selenophene ring, a silole ring, a germole ring, and a phosphole ring. The above-described substituent and condensed ring may have a substituent(s) and may be condensed with other ring(s), respectively. As the substituent, those exemplified above with respect to R¹ to R³ may be applied.

The aromatic hydrocarbon ring or aromatic heterocyclic ring formed by Q is preferably a benzene ring, a pyridine ring, a pyrazine ring, a pyrimidine ring, a triazine ring, a pyrrole ring, a pyrazole ring, an imidazole ring, a triazole ring, an oxazole ring, a thiazole ring, a furan ring, or a thiophene ring; more preferably a benzene ring, a pyridine ring, a pyrazine ring, a pyrrole ring, a pyrazole ring, an imidazole ring, an oxazole ring, a thiazole ring, or a thiophene ring; further preferably a benzene ring, a pyridine ring, a pyrazine ring, a pyrazole ring, an imidazole ring, or a thiophene ring; and particularly preferably a benzene ring, a pyridine ring, or a pyrazine ring.

In formula (IV), the position in the molecule of the -SO₂C(R⁴)(R⁵)(R⁶) group bonding to the phthalocyanine skeleton is not particularly limited, but it is preferable that the group bonds, as a substituent, to the aromatic hydrocarbon ring or aromatic hetero ring formed by Q. R⁴, R⁵ and R⁶ each have the same meanings as those of R¹, R², and R³ in formula (III) and the preferable ranges of R⁴, R⁵ and R⁶ are also the same as those of R¹, R², and R³. n is a natural number; and when n is 2 or more, a plurality of the -SO₂C(R⁴)(R⁵)(R⁶) groups may be the same or different from each other.

In formula (IV), M represents a metal atom or hydrogen atoms. When M represents hydrogen atoms, two hydrogen atoms bond to any two nitrogen atoms of N¹ to N⁴, separately i.e. one by one.

When M represents a metal atom, it may be any metal as long as it forms a stable complex, and examples thereof include Li, Na, K, Be, Mg, Ca, Ba, Al, Si, Hg, Cr, Fe, Co, Ni, Cu, Zn, Ge, Pd, Cd, Sn, Pt, Pb, Sr, V, Mn, Ti, In and Ga. The metal atom may be combined with a substituent, and examples of the substituent that can be used are the same as those mentioned in the above for R¹ to R³.

M is preferably Mg, Ca, AlCl, SiCl₂, Fe, Co, Ni, Cu, Zn, Pd, Sn, SnCl₂, Pt, Pb, V=O, Mn, or Ti=O; more preferably Fe, Co, Ni, Cu, or Zn; and most preferably Cu or Zn. Herein, it is also preferable that M represents hydrogen atoms, in the case where M represents hydrogen atoms in formula (IV), the compound is represented by formula (IV').

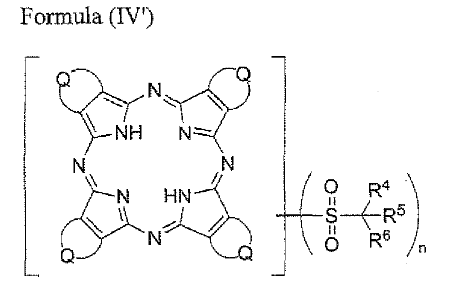

In formula (IV'), Q, R⁴, R⁵, R⁶ and n have the same meanings as those of Q, R⁴, R⁵, R⁶ and n in formula (IV) described above, and preferable ranges thereof are also the same.

With respect to a phthalocyanine compound having a plurality of substituents, generally there can be positional isomers that are different from each other in the bonding position of the substituent. There is no exception also in the phthalocyanine compound according to the first embodiment of the present invention, and several kinds of positional isomers thereof are considered according to the occasion. In the first embodiment of the present invention, the phthalocyanine compound to be used may be a single compound, or a mixture of positional isomers. In the case where the compound is a mixture of positional isomers, the number of positional isomers in the mixture, the substitution position of substituents in the positional isomers, and a mixing ratio of the positional isomers can be set arbitrarily.

Specific examples of preferable phthalocyanine compounds for use in the first embodiment of the present invention are described below, but the present invention is not limited to these exemplified compounds.

In Tables 1 to 4 below, for example, the expression "R^{α1}/R^{α2}" means any one of R^{α1} or R^{α2}. Accordingly, the compound described with this expression is a mixture of substitution-position isomers. Further, when R^{α1} to R^{α8}, or R^{β1} to R^{β8} each represent non-substitution, namely they are each a hydrogen atom, this expression is omitted. The * mark in a substituent indicates a binding position to the phthalocyanine derivative represented by formula (V). "Bu" represents a butyl group, and "Me" represents a methyl group.

**Table 1 Specific examples of the phthalocyanine derivative that can be used in the present invention**

| | | | |
|---|---|---|---|
| 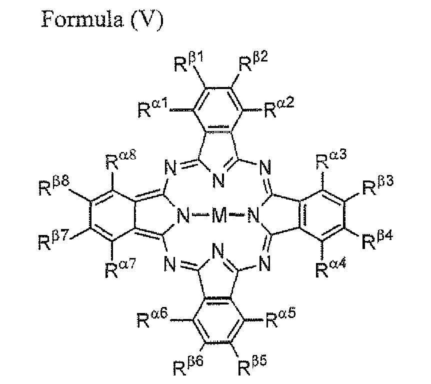 | | | |

| No. | Substitution position and Substituent | | M |
|---|---|---|---|
| (1) | R^{α1}/R^{α2}, R^{α3}/R^{α4}, R^{α5}/R^{α6}, R^{α7}/R^{α8} | 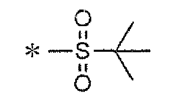 | Cu |
| (2) | R^{α1}R^{α2}, R^{α3}/R^{α4}, R^{α5}/R^{α6}, R^{α7}/R^{α8} | 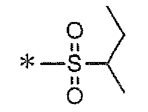 | Cu |
| (3) | R^{α1}/R^{α2}, R^{α3}/R^{α4}, R^{α6}/R^{α6}, R^{α7}/R^{α8} | 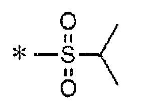 | Cu |
| (4) | R^{α1}/R^{α2}, R^{α3}/R^{α4}, R^{α5}/R^{α6}, R^{α7}/R^{α8} | 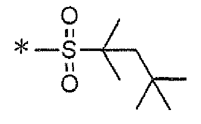 | Cu |
| (5) | R^{α1}/R^{α2}, R^{α3}/R^{α4}, R^{α5}/R^{α6}, R^{α7}/R^{α8} | 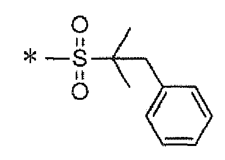 | Cu |

**Table 2 (Continued from Table 1)**

| No. | Substitution position and Substituent | | M |
|---|---|---|---|
| (6) | R^{α1}/R^{α2}, R^{α3}/R^{α4}, R^{α5}/R^{α6}, R^{α7}/R^{α8} | 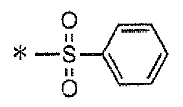 | Cu |
| (7) | R^{βl}/R^{β2}, R^{β3}/R^{β4}, R^{β5}/R^{β6}, R^{β7}/R^{β8} | 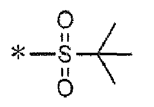 | Cu |
| (8) | R^{β1}/R^{β2}, R^{β3}/R^{β4}, R^{β5}/R^{β6}, R^{β7}/R^{β8} | 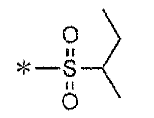 | Cu |
| (9) | R^{β1}/R^{β2}, R^{β3}/R^{β4}, R^{β5}/R^{β6}, R^{β7}/R^{β8} | 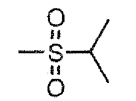 | Cu |
| (10) | R^{β1}/R^{β2}, R^{β3}/R^{β4}, R^{β5}/R^{β6}, R^{β7}/R^{β8} | 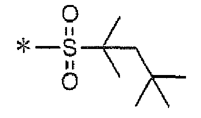 | Cu |
| (11) | R^{β1}/R^{β2}, R^{β3}/R^{β4}, R^{β5}/R^{β6}, R^{β7}/R^{β8} | 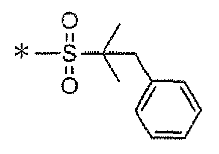 | Cu |
| (12) | R^{β1}/R^{β2}, R^{β3}/R^{β4}, R^{β5}/R^{β6}, R^{β7}/R^{β8} | 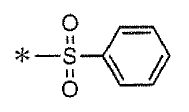 | Cu |
| (13) | R^{α1}/R^{α2}, R^{α3}/R^{α4}, R^{α5}/R^{α6}, R^{α7}/R^{α8} | 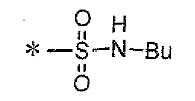 | Cu |

**Table 3 (Continued from Table 2)**

| No. | Substitution position and Substituent | | | M |
|---|---|---|---|---|
| (14) | R^{α1}/R^{α2}, R^{α3}/R^{α4}, R^{α5}/R^{α6}, R^{α7}/R^{α8} | | -SO₂N(*i*-C₅H₁₁)₂ | Cu |
| (15) | R^{α**1**}/R^{α2}, R^{α3}/R^{α4}, R^{α5}/R^{α6}, R^{α7}/R^{α8} | -SO₂NH(2-*s*-butoxy-5-*t*-amylphenyl) | | Cu |
| (16) | R^{α1}/R^{α2}, R^{α3}/R^{α4}, R^{α5}/R^{α6} | -SO₂NH(CH₂)₃O(2,4-di-*t*-amylphenyl) | | Cu |
| | R^{α7}/R^{α8} | | -SO₃H | |
| (17) | R^{α1}/R^{α2}, R^{α3}/R^{α4}, R^{α5}/R^{α6}, R^{α7}/R^{α8} | | -SO₂N(3-methoxypropyl)₂ | Ni |
| (18) | R^{α1}/R^{α2}, R^{α3}/R^{α4}, R^{α5}/R^{α6}, R^{α7}/R^{α8} | | -SO₂NMe(cyclohexyl) | Ni |
| (19) | R^{α1}/R^{α2}, R^{α3}/R^{α4}, R^{α5}/R^{α6}, R^{α7}/R^{α8} | | -SO₂N(3-*i*-propoxyphenyl)₂ | Ni |
| (20) | R^{α1}/R^{α2}, R^{α3}/R^{α4}, R^{α5}/R^{α6}, R^{α7}/R^{α8} | -SO₂NH(2-*i*-amyloxycarbonylphenyl) | | Pd |
| (21) | R^{α1}/R^{α2}, R^{α3}/R^{α4}, R^{α5}/R^{α6}, R^{α7}/R^{α8} | -SO₂NH(2,4,6-trimethylphenyl) | | Pd |
| (22) | R^{α1}/R^{α2}, R^{α3}/R^{α4}, R^{α5}/R^{α6}, R^{α7}/R^{α8} | | -SO₂(4-morpholino) | Co |
| (23) | R^{α1}/R^{α2}, R^{α3}/R^{α4}, R^{α5}/R^{α6}, R^{α7}/R^{α8} | | -SO₂N(C₂H₅)(4-fluorophenyl) | Fe |
| (24) | R^{α1}/R^{α2}, R^{α3}/R^{α4}, R^{α5}/R^{α6} | | -SO₂NH(CH₂)₃N(C₂H₅)₂ | Cu |
| (25) | R^{α1}/R^{α2}, R^{α3}/R^{α4}, R^{α5}/R^{α6}, R^{α7}/R^{α8} | | -SO₂(2-*n*-propoxyphenyl) | Cu |
| (26) | R^{α1}/R^{α2}, R^{α3}/R^{α4}, R^{α5}/R^{α6}, R^{α7}/R^{α8} | -SO₂(2-*n*-butoxy-5-*t*-butylphenyl) | | Ni |
| (27) | R^{α1}/R^{α2}, R^{α3}/R^{α4}, R^{α5}/R^{α6}, R^{α7}/R^{α8} | -SO₂(2-methoxycarbonylphenyl) | | Co |
| (28) | R^{α1}/R^{α2}, R^{α3}/R^{α4}, R^{α5}/R^{α6}, R^{α7}/R^{α8} | | | Cu |
| | | -SO₂(CH₂)₄O(2-chloro-4-*t*-amylphenyl) | | |
| (29) | R^{α1}/R^{α2}, R^{α3}/R^{α4}, R^{α5}/R^{α6}, R^{α7}/R^{α8} | | -SO₂(CH₂)₂CO₂-*i*-C₄H₉ | Pd |
| (30) | R^{α1}/R^{α2}, R^{α3}/R^{α4}, R^{α5}/R^{α6}, R^{α7}/R^{α8} | | -SO₂(cyclohexyl) | Cu |
| (31) | R^{α1}/R^{α2}, R^{α3}/R^{α4}, R^{α5}/R^{α6}, R^{α7}/R^{α8} | | | Ni |
| | | -SO₂{4-(2-*s*-butoxybenzoylamino)phenyl} | | |
| (32) | R^{α1}/R^{α2}, R^{α3}/R^{α4}, R^{α5}/R^{α6} | -SO₂(2,6-dichloro-4-methoxyphenyl) | | Pd |

**Table 4 (Continued from Table 3)**

| No. | Substitution position and Substituent | | | | M |
|---|---|---|---|---|---|
| (33) | R^{α1}/R^{α2}, R^{α3}/R^{α4}, R^{α5}/R^{α6} | -SO₂CH(Me)CO₂CH₂CH(C₂H₅)-*n*-C₄H₉ | | | Mg |
| (34) | R^{α1}/R^{α2}, R^{α3}/R^{α4}, R^{α5}/R^{α6}, R^{α7}/R^{α8} | | -SO₂{2-(2-ethoxyethoxy)phenyl} | | Zn |
| | R^{β1}/R^{β2}, R^{β3}/R^{β4}, R^{β5}/R^{β6}, R^{β7}/R^{β8} | | | -C₂H₅ | |
| (35) | R^{α1}/R^{α2}, R^{α3}/R^{α4}, R^{α5}/R^{α6}, R^{α7}/R^{α8} | | | -SO₂N(CH₂CH₂OMe)₂ | Cu |
| (36) | R^{α1}/R^{α2}*,* R^{α3}/R^{α4}, R^{α5}/R^{α6}, R^{α7}/R^{α8} | | | -SO₂CH₃ | Ni |
| (37) | R^{α1}/R^{α2}, R^{α3}/R^{α4}, R^{α5}/R^{α6}, R^{α7}/R^{α8} | | | -SO₂-*s*-C₄H₉ | Zn |
| (38) | R^{α1}/R^{α2}, R^{α3}/R^{α4}, R^{α5}/R^{α6}, R^{α7}/R^{α8} | | | -SO₂-*s*-C₄H₉ | Mg |
| (39) | R^{α1}/R^{α2}, R^{α3}/R^{α4}, R^{α5}/R^{α6}, R^{α7}/R^{α8} | | | -SO₂CH(CH₃)CO₂CH₃ | Cu |
| (40) | R^{α1}/R^{α2}, R^{α3}/R^{α4},R^{α5}/R^{α6}, R^{α7}/R^{α8} | | | -SO₂C₆H₅ | Cu |
| (41) | R^{α1}/R^{α2}, R^{α3}/R^{α4}, R^{α5}/R^{α6}, R^{α7}/R^{α8} | | | -SO₂N(*i*-C₅H₁₁)₂ | Cu |
| (42) | R^{α1}/R^{α2}, R^{α3}/R^{α4}, R^{α5}/R^{α6}, R^{α7}/R^{α8} | | | -SO₂CH(CH₃)₂ | Cu |
| (43) | R^{α1}/R^{α2}/R^{β1}R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | | | Cu |
| | 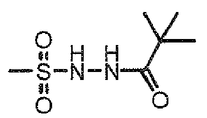 | | | | |
| (44) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | | | Cu |
| | 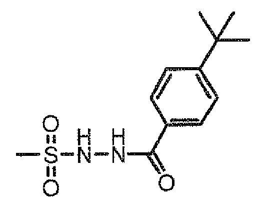 | | | | |
| (45) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | | | Cu |
| | 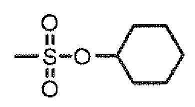 | | | | |

**Table 5 (Continued from Table 4)**

| No. | Substitution position and Substituent | | M |
|---|---|---|---|
| (46) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | Cu |
| | 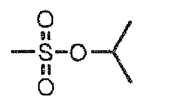 | | |
| (47) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | Cu |
| | 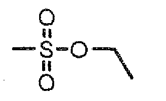 | | |
| (48) | R^{α1}/R^{α2}/R^{β3}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} | | Cu |
| | 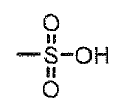 | | |
| (49) | R^{α1}/R^{α2}, R^{α3}/R^{α4}, R^{α5}/R^{α6}, R^{α7}/R^{α8} | 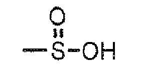 | Cu |
| (50) | R^{α1}/R^{α2}, R^{α3}/R^{α4}, R^{α5}/R^{α6}, R^{α7}/R^{α8} | 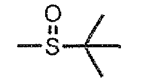 | Cu |
| (51) | R^{α1}/R^{α2}, R^{α3}/R^{α4}, R^{α5}/R^{α6}, R^{α7}/R^{α8} | 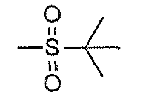 | Zn |
| (52) | R^{α1}/R^{α2}, R^{α3}/R^{α4}, R^{α5}/R^{a6}, R^{α7}/R^{α8} | 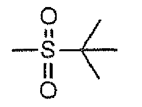 | 2H |
| (53) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} -SO₃H | | Zn |
| (54) | R^{α1}/R^{α2}/R^{β1}/R^{β2}, R^{α3}/R^{α4}/R^{β3}/R^{β4}, R^{α5}/R^{α6}/R^{β5}/R^{β6}, R^{α7}/R^{α8}/R^{β7}/R^{β8} -SO₃H | | 2H |

Phthalocyanine-ring formation reactions for the phthalocyanine compounds in the first embodiment of the present invention can be carried out, according to the methods described by Hirofusa Shirai, Nagao Kobayashi (editors and authors), "phthalocyanine -Chemistry and Function-", pp. 1-62, Industrial Publishing & Consulting, Inc. (1997), and Ryo Hirohashi, Kei-ichi Sakamoto & Eiko Okumura, "Phthalocyanine as a functional dye", pp. 29-77, Industrial Publishing & Consulting, Inc. (2004).

Typical examples of the method for synthesizing phthalocyanine compounds include a Weiler method, a phthalonitrile method, a lithium method, a subphthalocyanine method, and a chlorinated phthalonitrile method, as described in the above literatures. The phthalonitrile method can be preferably applied to the first embodiment of the present invention. Specifically, it is preferable to conduct a phthalocyanine ring-forming reaction using, as a raw material, a compound having a substituent represented by formula (I), such as t-butylsulfonylphthalonitrile. In the phthalocyanine ring-forming reaction, there is no particular limitation to reaction conditions. In the ring-forming reaction, it is preferable to add various kinds of metals that act as central metals in the phthalocyanine. Alternatively, after synthesizing a phthalocyanine compound free from any central metal, a desired metal may be introduced to the phthalocyanine compound. As a reaction solvent, there is no particular limitation, but a high boiling point solvent is preferable. Beside, an acid or a base may be used to accelerate a ring-forming reaction. Optimum reaction conditions are different depending on the structure of a target phthalocyanine compound, but they can be determined in reference to specific reaction conditions as described in the above literatures.

As raw materials that can be used in the synthesis of the phthalocyanine compound, use may be made of phthalic acid anhydride, phthalimide, phthalic acid and a salt thereof, phthalic acid diamide, phthalonitrule, 1,3-diiminoisoindoline, and derivatives thereof. These raw materials may be synthesized through any usual synthetic method.

Further, the compound that can be used in the first embodiment of the present invention may be produced by introducing a substituent represented by formula (I) to the solvent-insoluble compound, with reference to the descriptions in JP-A-2005-119165, or the like.

In the method of producing a desubstituted compound according to the first embodiment of the present invention, it is preferable to begin by dissolving the solvent-soluble precursor compound A-(B)ₘ that is used in the first embodiment of the present invention, in a solvent.

As the solvent, water and/or an organic solvent may be used. As the organic solvent, use may be made, for example, of a hydrocarbon-based solvent, such as hexane, octane, decane, toluene, xylene, ethylbenzene, 1-methylnaphthalene, or 1,2-dichlorobenzene; a ketone-based solvent, such as acetone, methyl ethyl ketone, methyl isobutyl ketone, or cyclohexanone; a halogenated hydrocarbon-based solvent, such as dichloromethane, chloroform, tetrachloromethane, dichloroethane, trichloroethane, tetrachloroethane, chlorobenzene, dichlorobenzene, or chlorotoluene; an ester-based solvent, such as ethyl acetate, butyl acetate, or amyl acetate; an alcohol-based solvent, such as methanol, propanol, butanol, pentanol, hexanol, cyclohexanol, methyl cellosolve, ethyl cellosolve, or ethylene glycol; an ether-based solvent, such as dibutyl ether, tetrahydrofuran, dioxane, or anisole; or a polar solvent, such as N,N-dimethylformamide, N,N-dimethylacetamide, 1-methyl-2-pyrrolidone, 1-methyl-2-imidazolidinone, or dimethylsulfoxide.

The concentration of the solvent-soluble precursor compound in a solvent is not particularly limited, and is varied depending on the end use, but the solvent-soluble precursor compound may be dissolved in the concentration range that is defined as the above-described "solvent-soluble".

In the method of producing a desubstituted compound according to the first embodiment of the present invention, after coating or the like with a solution of the solvent-soluble precursor compound dissolved in a solvent, the solvent-soluble group is desubstituted by applying an external stimulation such as heating to the precursor compound, and the precursor compound can be converted to a solvent-insoluble compound.

A heat treatment with a heater is representative as the external stimulation. The heating temperature is preferably 150 °C or higher, more preferably 200 °C or higher, and further preferably 250 °C or higher. Further, the upper limit of heating temperature is preferably 550 °C. or lower, more preferably 500 °C or lower, and further preferably 400 °C or lower. The higher the temperature is, the shorter the reaction time is. The lower the temperature is, the longer the period of time necessary for the desubstitution reaction is. The heating operation is preferably conducted under the inactive atmosphere such as nitrogen gas or argon gas.

It is possible to subject the target compound to desubstitution of not all but a part of the substituents represented by formula (I), by changing the heating temperature and/or the heating time according to the intended use, thereby making it possible to control properties of the thus-produced compound. For example, when the compound is used in an organic semiconductor film, mobility can be controlled.

As for the heating method, in addition to the heating method of transferring heat with a heater, heating may be conducted by providing a light-absorbing layer in the vicinity of the layer containing the solvent-soluble precursor compound for use in the first embodiment of the present invention, and absorbing light by the light-absorbing layer.

As for the external stimulation, any treatment for decomposing or releasing the substituent represented by formula (I) may be carried out. In addition to the above-described heat treatment, photolytic decomposition and/or chemical decomposition (by use of an organic or inorganic acid or base) may be carried out. These conversion methods may be combined with each other.

In the case of the photolytic decomposition treatment, use may be made, for example, of infrared lamp or irradiation of light of wavelength that a compound in interest absorbs (for example, exposure to light of wavelength 405 nm or less). On this occasion, a semiconductor laser may be used. Examples of semiconductor laser beam include a near-infrared region laser beam (generally, a laser beam of wavelength around 780 nm), a visible laser beam (generally, a laser beam of wavelength in the range of 630 nm to 680 nm), and a laser beam of wavelength of 390 nm to 440 nm.

Especially preferable laser beam is a laser beam having a wavelength region of 390 nm to 440 nm, and a semiconductor laser beam having a laser emission wavelength of 440 nm or less is preferably used. Among these semiconductor laser beam, examples of preferable light sources include a bluish-violet semiconductor laser beam having an emission wavelength region of 390 nm to 440 nm (more preferably from 390 nm to 415 nm), and a bluish-violet SHG laser beam having a center emission wavelength of 425 nm that has been converted to a half wavelength of the infrared semiconductor laser beam having a center emission wavelength of 850 nm by using an optical waveguide.

Further, as for the organic or inorganic acid or base that can be preferably used in the case of the chemical decomposition, it is preferable to use any of acids, such as mineral acids (for example, sulfuric acid, hydrochloric acid, hydrobromic acid, nitric acid, phosphoric acid), organic carboxylic acid (for example, acetic acid, oxalic acid, formic acid, propionic acid, benzoic acid), or sulfonic acids (for example, methane sulfonic acid, ethane sulfonic acid, benzene sulfonic acid, p-toluene sulfonic acid), more preferably sulfuric acid, hydrochloric acid, hydrobromic acid, or acetic acid, and especially preferably sulfuric acid, or hydrochloric acid. These acids may be used singly or in combination of two or more kinds. Examples of preferable bases include organic bases, alkyl metals, and metal hydrides (for example, sodium hydride), more preferably triethylamine, pyridine, or sodium hydride, and especially preferably triethylamine or pyridine.

In the embodiment of obtaining a phthalocyanine compound as the above-described solvent-insoluble compound, an unsubstituted phthalocyanine compound can be obtained, by dissolving, in a solvent, a phthalocyanine compound having a solvent-soluble group, in which such a substituent bonds to a carbon atom in a group to give the phthalocyanine compound, and then causing desubstitution of the substituent from the compound by applying an external stimulation such as heat.

With respect to the phthalocyanine compounds, attention is currently focused on their molecular properties. However, studies on the phthalocyanine compounds have been put in irons owing to their solvent-insolubility. According to the first embodiment of the present invention, it is possible to perform a thin film formation or the like using a solution in which a phthalocyanine compound having a specific solvent-soluble group as a substituent has been dissolved in a commonly-used solvent, without introduction of a special substituent or molecular modification. Thereafter, by conducting the desubstitution, a thin film composed of an unsubstituted phthalocyanine compound can be obtained. As a result, semiconductor thin films or microfabricated films can be effectively produced, without requiring complicated processes.

In the embodiment of obtaining a pigment as the above-described solvent-insoluble compound, after dissolving, in a solvent, a pigment precursor of a structure in which the pigment is modified with a solvent-soluble group, the pigment precursor is converted to the pigment by applying an external stimulation such as heating. As a result, it is possible to obtain a pigment dispersion in which pigment fine-particles are dispersed in a solvent. The particle size of the pigment fine-particles is not particularly limited, but in the case of obtaining the pigment as nanometer sized fine-particles, the average particle size of the pigment is preferably from 1 to 1,000 nm, and more preferably from 10 nm to 500 nm. The thus-obtained pigment fine-particles may be preferably used for applications, such as coating, printing ink, electrophotographic toner, inkjet ink, color filter, or the like.

As the uses of the dye (coloring matter) obtained in an embodiment to obtain a dye compound via the method of producing a desubstituted compound according to the first embodiment of the present invention, mention may be made of image-recording materials for forming images, particularly color images. Specifically, mention may be made of recording materials for inkjet system described below in details, and in addition, heat-sensitive recording materials, pressure-sensitive recording materials, recording materials using an electrophotographic system, transfer-type silver halide light-sensitive materials, printing inks, recording pens, and the like. Preferably, mention may be made of recording materials for inkjet system, heat-sensitive transfer type recording materials, and recording materials using an electrophotographic system. Further preferably, mention may be made of recording materials for inkjet system.

Further, the compounds are also applicable to color filters for recording/reproducing color images for use in solid-state image pickup devices such as CCDs, and displays such as LCDs and PDPs, and dyeing solutions for dyeing various fibers.

The dyes that can be obtained by the first embodiment of the present invention are used by having been adjusted in physical properties, such as solubility in a solvent, dispersibility, and thermal transfer property suitable for the intended use, by substituents thereon. Further, the dyes that can be obtained by the first embodiment of the present invention are also usable in dissolved state, in emulsified dispersion state, and further in solid dispersion state, according to the system to be used.

In an embodiment of producing pigment fine-particles according to the first embodiment of the present invention, ink can be produced using the pigment fine-particles obtained therein. Thus, the ink means an ink containing, as a dye, at least one kind of the pigment fine-particles obtained by the first embodiment of the present invention.

The ink can contain medium. It is particularly suitable as ink for inkjet recording when a solvent is used as the medium. The ink can be produced by using an oleophilic medium or an aqueous medium as the medium, and dissolving and/or dispersing the dye obtained by the first embodiment of the present invention therein. Preferred is the case where an aqueous medium is used. The ink according to the present invention includes a composition for ink containing no medium.

If required, other additives may be contained in the ink. Examples of those other additives include known additives, such as an anti-drying agent (wetting agent), an antifading agent, an emulsion stabilizer, a penetration accelerator, a UV absorber, an antiseptic agent, an antifungal agent, a pH adjuster, a surface tension regulator, an antifoaming agent, a viscosity modifier, a dispersant, a dispersion stabilizer, a rust inhibitor, and a chelating agent (as described in JP-A-2003-306623). These various additives are directly added to an ink liquid for a water-soluble ink. When an oleophilic dye is used in the form of a dispersion, generally, it is added to the dispersion after preparation of a dye dispersion, but it may be added to an oil phase or an aqueous phase for the preparation.

When the dye that can be obtained by the first embodiment of the present invention is dispersed in an aqueous medium, preferably, as in JP-A-11-286637, JP-A-2001-240763, JP-A-2001-262039, and JP-A-2001-247788, colored fine-particles containing the dye and an oil-soluble polymer are dispersed in an aqueous medium, or as in JP-A-2001-262018, JP-A-2001-240763, and JP-A-2001-335734, the dye that can be obtained by the first embodiment of the present invention dissolved in a high-boiling-point organic solvent is dispersed in an aqueous medium. As the specific method for dispersing the dye that can be obtained by the first embodiment of the present invention in an aqueous medium, the oil-soluble polymer, the high-boiling-point organic solvent, and additives, to be used, and the amounts of those to be used, those described in the foregoing patent publications may be preferably used. Alternatively, the dye may also be dispersed in the form of fine particles still in solid form. For dispersion, a dispersant or a surfactant may be used.

As the dispersing devices, use may be made of a simple stirrer or impeller stirring system, an in-line stirring system, a mill system (such as a colloid mill, a ball mill, a sand mill, an attritor, a roll mill, or an agitator mill), an ultrasonic system, a high-pressure emulsifying and dispersing system (high-pressure homogenizer; as specific commercially available devices, Gaulin Homogenizer, Microfluidizer, DeBEE2000, and the like, each trade name). The details of the method for preparing the inkjet recording ink are described in, other than the foregoing patent publications, respective publications of JP-A-5-148436, JP-A-5-295312, JP-A-7-97541, JP-A-7-82515, JP-A-7-118584, JP-A-11-286637, JP-A-2001-2271003, which is also usable for the preparation of the inkjet recording ink using the dye obtained by the first embodiment of the present invention.

As the aqueous medium, use may be made of a mixture containing water as a main component, and if desired, containing a water-miscible organic solvent added therein. As the examples of the water-miscible organic solvent, those described in JP-A-2003-306623 are usable. The water-miscible organic solvents may also be used in combination of two or more thereof.

The dye that can be obtained by the first embodiment of the present invention is preferably contained in an amount of 0.1 part by mass or more and 20 parts by mass or less, more preferably contained in an amount of 0.2 part by mass or more and 10 parts by mass or less, and further preferably contained in an amount of 0.5 to 9 parts by mass, per 100 parts by mass of the inkjet recording ink. Further, in the ink for inkjet, other dyes may be used in combination with the dye that can be obtained by the first embodiment of the present invention. When two or more dyes are used in combination, the total amount of the dyes to be contained preferably falls within the foregoing range.

The ink may be used not only for the formation of a monochrome image but also for the formation of a full color image. For the formation of a full color image, a magenta tone ink, a cyan tone ink, and a yellow tone ink can be used. Further, for adjusting the tone, a black tone ink may further be used.

Further, the ink for inkjet recording can use, other than the dye that can be obtained by the first embodiment of the present invention, other cyan dyes at the same time. As the applicable yellow dyes, the applicable magenta dyes, and the applicable cyan dyes, any ones can be used, respectively, and respective dyes described in paragraph Nos. 0090 to 0092 of JP-A-2003-306623 are usable. As the applicable black materials, mention may be made of, other than disazo, trisazo, and tetraazo dyes, a dispersion of carbon black.

The inkjet recording method provides energy to the inkjet recording ink, and forms an image on a known image-receiving material, i.e., ordinary paper and resin-coated paper, such as inkjet-specific paper, film, electrophotographic common paper, cloth, glass, metal, ceramic, or the like, as described in JP-A-8-169172, JP-A-8-27693, JP-A-2-276670, JP-A-7-276789, JP-A-9-323475, JP-A-62-238783, JP-A-10-153989, JP-A-10-217473, JP-A-10-235995, JP-A-10-337947, JP-A-10-217597, and JP-A-10-337947. As the inkjet recording method, the description of paragraph No. 0093 to 0105 of JP-A-2003-306623 is applicable.

For the formation of an image, a latex polymer compound may be used in combination for the purpose of imparting the glossiness or the water resistance, or improving the weatherability. The timing of imparting the latex polymer compound to the image-receiving material may be before or after imparting the colorant or simultaneously with it. Accordingly, the receiving site may be in the image-receiving paper or in the ink. Alternatively, the latex polymer may be used in the form of a liquid material of the latex polymer alone. Specifically, use may be preferably made of the methods as described in JP-A-2002-166638, JP-A-2002-121440, JP-A-2002-154201, JP-A-2002-144696, JP-A-2002-080759, and Japanese Patent Application Nos. 2000-299465 and 2000-297365.

The content of the dye that can be obtained by the first embodiment of the present invention per 100 parts by mass of the color toner has no particular limitation, but it is preferably 0.1 part by mass or more, more preferably 1 to 20 parts by mass, and most preferably 2 to 10 parts by mass.

As the color toner binder resins for introducing the dye that can be obtained by the first embodiment of the present invention, all the commonly used binders are usable. For example, styrene-series resins, acrylic-series resins, styrene/acrylic-series resins, and polyester resins may be mentioned.

To the toner, inorganic fine-powder and organic fine-particles may be externally added for the purposes of improving the fluidity, controlling the electric charge, or other purposes. Silica fine-particles or titania fine-particles, surface-treated with a coupling agent containing an alkyl group are preferably used. These preferably have a number average primary particle diameter of 10 to 500 nm, and preferably are added into the toner in an amount of 0.1 to 20 mass%.

All the release agents which have been conventionally used may be used as the release agents. Specifically, mention may be made of olefins, such as low-molecular-weight polypropylenes, low-molecular-weight polyethylenes, and ethylene/propylene copolymers; microcrystalline wax, carnauba wax, sazol wax, paraffin wax, and the like. These are each preferably added into the toner in an amount of 1 to 5 mass%.

The charge-control agent may be added, if required. They are preferably achromatic from the viewpoints of color-forming property. Examples thereof may include those having a quaternary ammonium salt structure or a calyx allene structure.

The carrier to be used may be either an uncoated carrier composed of only magnetic material particles of iron, ferrite, or the like, or a resin-coated carrier obtained by coating the surface of a magnetic material particle with a resin or the like. The average particle diameter of this carrier is preferably 30 to 150 µm in terms of volume average particle diameter.

The method for forming an image, to which the toner is applicable, has no particular limitation. Examples of the method include a method in which color images are repeatedly formed on a photosensitive material, and then transferred, to form an image; and a method in which images formed on a photosensitive material are transferred to an intermediate transfer material and the like sequentially, then a color image is formed on the intermediate transfer material or the like, and then is transferred to an image-forming member such as paper, to form a color image.

The heat-sensitive recording material is composed of: an ink sheet, including the dye that can be obtained by the first embodiment of the present invention coated on a support together with a binder; and an image-receiving sheet, which fixes the dye transferred in accordance with a heat energy applied from a thermal head in response to an image recording signal. The ink sheet can be formed in the following manner.
The compound that can be obtained by the first embodiment of the present invention is dissolved in a solvent with a binder. Alternatively, it is dispersed in the form of fine particles in a solvent. As a result, an ink liquid is prepared, and the ink is applied on a support, and appropriately dried, to form the ink sheet. The amount of the ink to be coated on the support has no particular restriction, but it is preferably 30 to 1,000 mg/m². As the preferred binder resins, ink solvents, supports, and further image-receiving sheets, those described in JP-A-7-137466 can be preferably used.

In order to apply the heat-sensitive recording material to a heat-sensitive recording material capable of full-color-image recording, preferably a cyan ink sheet containing a heat diffusible cyan dye capable of forming a cyan image, a magenta ink sheet containing a heat diffusible magenta dye capable of forming a magenta image, and a yellow ink sheet containing a heat diffusible yellow dye capable of forming a yellow image are sequentially applied to coat on a support for the formation. Alternatively, if required, another ink sheet containing a black-image-forming material may be further formed.

As the methods for forming a color filter, there is a method in which first, a pattern is formed with a photoresist, followed by dyeing, or a method in which as disclosed in JP-A-4-163552, JP-A-4-128703, and JP-A-4-175753, a pattern is formed by a photoresist to which a dye has been added. As the methods used for introducing the dye that can be obtained by the first embodiment of the present invention into a color filter, any of these methods may be used. As the preferred method, mention may be made of the following method for forming a color filter, as described in JP-A-4-175753 or JP-A-6-35182. A positive-type resist composition containing a thermosetting resin, a quinonediazide compound, a crosslinking agent, a dye, and a solvent is applied on a substrate. Then, the resultant substrate coated is exposed to light through a mask, to develop the exposed area. As a result, a positive-type resist pattern is formed, and the entire surface of the positive-type resist pattern is exposed to light. Then, the positive-type resist pattern thus exposed is hardened. Alternatively, according to a usual manner, a black matrix is formed, which can provide a R, G, and B primary color type or Y, M, and C complementary color type color filter. Also for the color filter, the amount of the dye to be used has no particular restriction, but it is preferably 0.1 to 50 mass%.

As the thermosetting resin, quinonediazide compound, crosslinking agent, and solvent, for use in this step, and the amounts thereof, those described in the foregoing patent documents may be preferably used.

When the solvent-insoluble compound shows crystallinity, if necessary, the crystalline system of the solvent-insoluble compound can be controlled, by using the production method according to the first embodiment of the present invention. When the solvent-soluble precursor compound having the substituent represented by formula (1) that is used in the first embodiment of the present invention shows an amorphous crystalline structure, the substituent is desubstituted by the method according to the first embodiment of the present invention, to convert the solvent-soluble precursor compound to a solvent-insoluble compound. As a result, amorphous-to-crystalline transformation can be caused. For example, copper phthalocyanine shows polymorphism. Specifically, crystal forms such as α, β, ε, γ, δ, π, χ, or R are reported (for example, see "Phthalocyanine as a functional dye, Basic Edition and Application Edition" (IPC)). In an embodiment of obtaining a phthalocyanine compound according to the first embodiment of the present invention, a controllable crystalline system is preferably α, β, or ε, and more preferably α, or β. In particular, hitherto, the metastable α-type crystal is produced according to an acid paste method, and the size of crystallite is small and the peak in X-ray diffraction measurement result is broad. In contrast, since α-type crystal can be efficiently produced by heating according to the first embodiment of the present invention, a sharp peak with a small half bandwidth is obtained and α-type crystal composed of large size crystallites can be produced.

In the first embodiment of the present invention, a thin film of the solvent-insoluble compound can be produced, by dissolving the solvent-soluble precursor compound in a solvent, coating a substrate with the resultant solution, drying, applying an external stimulation such as heating, thereby causing desubstitution of the solvent-soluble group. Examples of the substrate include a substrate sheet. The substrate may be a surface of another member or a wall surface.

Examples of the material of the substrate that can be used in this embodiment, include a variety of materials, for example, polyester films, such as polyethylenenaphthalate (PEN) or polyethyleneterephthalate (PET), and other materials, such as polyimide films, ceramics, silicon, quartz, or glass. Among these materials, ceramics, silicon, quartz and glass are preferable, and silicon, quartz and glass are more preferable. Further, any substrate may be selected in accordance with intended purposes. For example, a flexible substrate may be used for an application to a flexible device.

The thickness of the substrate is not particularly limited, but preferably from 1 to 1.000 µm, and more preferably from 10 to 800 µm.

In the first embodiment of the present invention, when a film formation is carried out according to a method of applying a solution of the solvent-soluble precursor compound on a substrate, the method is not particularly limited, but the film formation performed by a solution process is preferable in particular. Herein, the term film formation performed by a solution process" refers to a film-forming method which includes dissolving an organic compound in a solvent capable of dissolving the organic compound, and applying the resultant solution on a substrate, and then drying. As specific examples, use may be made of any usual method, such as a cast method, a blade coating method, a wire bar coating method, a splay coating method, a dip (immersion) coating method, a bead coating method, an air knife coating method, a curtain coating method, an inkjet coating method, a spin coating method, and a Langmuir-Blodgett (LB) method. In the first embodiment of the present invention, it is more preferable to use a cast method, a spin coat method, or an inkjet method. These solution processes make it possible to produce a large-size thin film having a flat surface with a low coat.

In the case of forming a film on a substrate by the solution process, a coating liquid is prepared by dissolving or dispersing the material to form the film in an appropriate organic solvent (e.g., a hydrocarbon-based solvent, such as hexane, octane, decane, toluene, xylene, ethylbenzene, 1-methylnaphthalene, or 1,2-dichlorobenzene; a ketone-based solvent, such as acetone, methyl ethyl ketone, methyl isobutyl ketone, or cyclohexanone; a halogenated hydrocarbon-based solvent, such as dichloromethane, chloroform, tetrachloromethane, dichloroethane, trichloroethane, tetrachloroethane, chlorobenzene, dichlorobenzene, or chlorotoluene; an ester-based solvent, such as ethyl acetate, butyl acetate, or amyl acetate; an alcohol-based solvent, such as methanol, propanol, butanol, pentanol, hexanol, cyclohexanol, methyl cellosolve, ethyl cellosolve, or ethylene glycol; an ether-based solvent, such as dibutyl ether, tetrahydrofuran, dioxane, or anisole; a polar solvent, such as N,N-dimethylformamide, N,N-dimethylacetamide, 1-methyl-2-pyrrolidone, 1-methyl-2-imidazolidinone, or dimethyl sulfoxide) and/or water, and the coating liquid thus prepared can be utilized in forming of the thin film by various coating methods.

The concentration of the compound for use in the first embodiment of the present invention in such a coating liquid is adjusted to a range of preferably 0,1 to 80 mass%, more preferably 0.1 to 10 mass%, and the film can be formed with an arbitrary thickness.

Further, in the film formation, a resin binder may be also used. In this case, a thin film can be formed, by dissolving or dispersing a layer-forming material and the resin binder in a suitable solvent described above, to prepare a coating liquid, and coating with the resultant coating liquid according to various coating methods. Examples of the resin binder include insulating polymers, such as polystyrene, polycarbonate, polyarylate, polyester, polyamide, polyimide, polyurethane, polysiloxane, polysulfone, polymethyl methacrylate, polymethyl acrylate, cellulose, polyethylene, and polypropylene; and copolymers of these polymers; photoconductive polymers, such as polyvinyl carbazol and polysilane, and electrically conductive polymers, such as polythiophen, polypyrrole, polyaniline, and polyparaphenylenevinilene. The resin binder may be used singly or, alternatively two or more kinds of the resin binders may be used in combination. Taking the mechanical strength of the thin film into consideration, preferred are resin binders high in glass transition temperatures.

It is preferable in characteristics of the resultant organic semiconductor not to use any resin binder, but the resin binder may be used according to the purposes. In that case, an amount of the resin binder to be used is not particularly limited, but preferably the binder is used from 0.1 to 30% by mass, based on the thin film.

Further, in the film formation, a substrate may be heated or cooled. It is possible to control film qualities or packing state of molecules in the film, by changing a temperature of the substrate. The substrate temperature, though not particularly limited, is preferably between 0 °C and 200 °C.

The solvent-soluble precursor compound for use in the first embodiment of the present invention is suitable for the film formation according to a solution process in particular, Although it is possible to form a film according to a vacuum process, for example, a physical vapor deposition method, such as a vacuum deposition method, a spattering method, an ion-plating method, or a molecular beam epitaxy (MBE) method, or a chemical vapor deposition (CVD) method, such as plasma polymerization, these vacuum processes are not preferable since they are high in production costs and are poor in flatness of the resultant film surface. Further, in order to form a film according to a solution process, it is necessary that materials be dissolved in the above-described solvents or the like, but the requirement for the solution process is not satisfied only by dissolving the materials. Generally, even a material for film formation according to a vacuum process can be dissolved in a solvent at some level. However, after dissolving a material in a solvent and then coating with the resultant solution in the solution process, there is a process of forming a thin film by evaporating the solvent. In this connection, many of the materials being unsuitable for the solution process have high crystallinity. Thus, these materials are crystallized in this process, and it is difficult to form a thin film of good quality. In contrast, the solvent-soluble precursor compound for use in the first embodiment of the present invention hardly causes such crystallization, and the solvent-soluble precursor compound is also excellent in this point.

The coating amount of the solution containing the solvent-soluble precursor compound varies depending on the kind of a solvent, the concentration of the solvent, or the like, but the coating amount is appropriately determined so that a film thickness of the thus-formed thin film would be preferably from 5 nm to 50 µm, and more preferably from 20 to 500 nm. The film thickness is, however, not limited to these ranges, and varies depending on the intended purposes.

Properties of the thus-formed film can be controlled by a post treatment. For example, morphology of the film or state of packing of molecules in the film can be altered, by a heat treatment or exposure to a solvent vapor, to improve characteristics of the film. Further, an oxidation or reduction reaction can be taken place, by exposing to an oxidizing or reducing gas or solvent, or other substance, or mixing with any of these materials, to control the association state in the film.

In the production method according to the first embodiment of the present invention, a precursor compound having a solubility to a solvent suitable for the solution process is used, as described above. Further, an external stimulation is applied to the precursor compound. The compounds to be used and to be obtained in the production method have storage stability, such as light resistance before and after the external stimulation. Namely, the solvent-soluble precursor compound and a target compound obtained by applying the external stimulation to the precursor, even though stored for a predetermined period of time, have resistance to decomposition or metamorphose. This point is different from the conventionally used precursor compound to which a Boc group is introduced. By using a compound having the specific substituent as a precursor, dissolution in various solvents becomes easy. Moreover, by applying an external stimulation such as heating to a solution or a coated film, the compound is efficiently desubstituted to release the substituent, and a useful compound can be obtained at a high yield. Further, this technique makes it possible to obtain high-purity pigment fine-particles and phthalocyanine compounds, and to efficiently form a thin film of these materials.

The second embodiment of the present invention is described below in detail.

The method of producing an organic semiconductor film according to the second embodiment of the present invention includes: a step of forming a film of a π-conjugated compound having a substituent represented by formula (2-1) (hereinafter, refer to as "compound for use in the second embodiment of the present invention") on a substrate; and a step of causing the substituent to release (to desubstitute) from the compound.

### (π-Conjugated compound)

In the second embodiment of the present invention, any compound may be used as the π-conjugated compound, so far as the compound has a broad π-conjugated plane. It is preferable that the π-conjugated compound has a structure in which any two or more of aromatic hydrocarbon rings or aromatic hetero rings {e.g. a benzene ring, a pyridine ring, a pyrazine ring, a pyrimidine ring, a triazine ring, a pyrrol ring, a pyrazole ring, an imidazole ring, a triazole ring, an oxazole ring, a thiazole ring, a furan ring, or a thiophene ring, and more preferably a benzene ring, a pyridine ring, a pyrazine ring, a pyrrol ring, a pyrazole ring, an imidazole ring, an oxazole ring, a thiazole ring, or a thiophene ring} are condensed, and/or linked by a covalent bond(s), and further π-electrons, which the aromatic hydrocarbon ring(s) and/or the aromatic hetero ring(s) each has, are delocalized over the entire condensed ring and/or linked rings by the interaction of ring condensation and/or linkage. The number of the aromatic hydrocarbon rings and/or the aromatic hetero rings that are condensed, and/or linked by a covalent bond(s) is preferably from 1 to 20, and more preferably from 2 to 12.

Specific examples of the π-conjugated compound in the second embodiment of the present invention, include condensed-polycyclic compounds such as tetracene, pentacene, triphenylene, and hexabenzocoronene; hetero ring oligomers such as quarterthiophene, and sexithiophene; phthalocyanines; and porphyrins.

Further, the π-conjugated compound in the second embodiment of the present invention is insoluble in a solvent, but it is possible to make the π-conjugated compound soluble in a solvent by introducing the substituent represented by formula (2-1) to the compound. Herein, the term "solvent-insoluble (being insoluble in a solvent)" is defined as showing solubility of less than 1% by mass, preferably less than 0.5% by mass, and more preferably less than 0.1% by mass, with respect to a solvent in interest when the solvent to which a compound in interest is added is heated under reflux and then cooled down to room temperature. Further, the term "solvent-soluble (being soluble in a solvent)" is defined as a compound showing solubility of 1% by mass or more, preferably 3% by mass or more, and further preferably 5% by mass or more, with respect to a solvent in interest when the solvent to which a compound in interest is added is heated under reflux and then cooled down to room temperature.

### (Substituent represented by formula (2-I))

The compound for use in the second embodiment of the present invention has a substituent represented by formula (2-I)

The substituent represented by formula (2-I) is described.

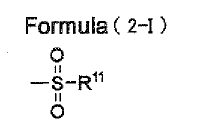

In formula (2-I), R¹¹ represents a substituent other than a hydrogen atom. The substituent represented by R¹¹ has the same meaning as the substituent represented by X in formula (I), and examples, specific examples and preferable examples of the substituent of R¹¹ are also the same as those of the X in formula (I).

The substituent represented by R¹¹ is preferably a halogen atom, a substituted or unsubstituted alkyl group having 1 to 30 carbon atoms, a substituted or unsubstituted aryl group having 6 to 30 carbon atoms, a 5- or 6-membered substituted or unsubstituted heterocyclic group, a hydroxyl group, a cyano group, a substituted or unsubstituted alkoxy group having 1 to 30 carbon atoms, a substituted or unsubstituted alkylcarbonyl group having 2 to 30 carbon atoms, a substituted or unsubstituted arylcarbonyl group having 7 to 30 carbon atoms, a substituted or unsubstituted alkoxycarbonyl group having 2 to 30 carbon atoms, or a substituted or unsubstituted aryloxycarbonyloxy group having 7 to 30 carbon atoms; more preferably a halogen atom, an alkyl- group having 1 to 30 carbon atoms, a hydroxyl group, a cyano group, a substituted or unsubstituted alkylcarbonyl group having 2 to 30 carbon atoms, or a substituted or unsubstituted alkoxycarbonyl group having 2 to 30 carbon atoms; further preferably a t-butyl group, a s-butyl group, an i-propyl group, a substituted or unsubstituted amino group, or a phenyl group; and most preferably a t-butyl group.

There is no restriction in the number of substituents represented by formula (2-I) that is present in the molecule. From the viewpoints of solubilities to solvents and film-forming properties, as the number of substituent increases, greater advantages are obtained. On the other hand, from the viewpoint of semiconductor characteristics, it is preferable that a change of volume between before and after desubstitution is as small as possible, because a change of packing of molecules in the film becomes small. Thus, it is preferable that the number of substituents represented by formula (2-1) that is present in the molecule is from 1 to 8, and more preferably from 1 to 4. When a plurality of the substituents represented by formula (2-I) are present in the molecule, they may be the same or different from each other.

A part of or all of the substituents represented by formula (2-1) can be readily desubstituted by an external stimulation such as heat. Further, since the substituent represented by formula (2-1) has an electron-withdrawing property, the resistance to oxidation of the π-conjugated compound is enhanced by the substituent, to stabilize the π-conjugated compound chemically.

### (Compound represented by formula (2-II))

The compound for use in the second embodiment of the present invention is preferably a compound represented by formula (2-11), from the viewpoints of chemical stability of the compound, semiconductor performance stability and semiconductor properties. In particular, a phthalocyanine compound is preferable. Herein, the term phthalocyanine compound refers to a compound having a phthalocyanine skeleton, and a phthalocyanine derivative in which a substituent bonds to phthalocyanine.

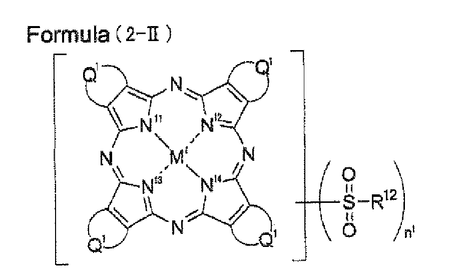

In formula (2-II), Q¹ has the same meaning as Q in formula (I), and examples, and preferable specific examples of Q¹ are also the same as those of Q in formula (I).

In formula (2-II), the -SO₂R¹² group bonding to the π-conjugated compound skeleton may bond to any position of the molecule, but it is preferable that the group bonds, as a substituent, to an aromatic hydrocarbon ring or an aromatic hetero ring, each of which is formed together with Q¹. R¹² has the same definitions as R¹¹ in formula (2-I), and the preferable range thereof is also the same as that of R¹¹. n¹ is a natural number. When n¹ is 2 or more, a plurality of the -SO₂R¹² groups may be the same or different from each other.

In formula (2-II), M¹ has the same meaning as M in formula (I), and examples, and preferable specific examples of M¹ are also the same as those of M in formula (I).

When M¹ is hydrogen atoms, the compound of formula (2-II) is represented by formula (2-II).

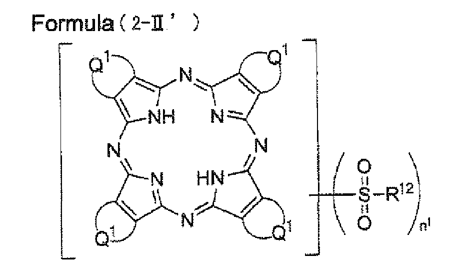

In formula (2-II'), Q¹, R¹² and n¹ have the same meanings as those of Q¹, R¹² and n¹ in formula (2-II) described above, and preferable ranges thereof are also the same.

### (Existence of Isomers)

With respect to a phthalocyanine compound having a plurality of substituents, generally there can be positional isomers that are different from each other in the bonding position of the substituent. There is no exception in the compound for use in the second embodiment of the present invention, and several kinds of positional isomers thereof are considered according to the occasion. In the second embodiment of the present invention, the phthalocyanine compound to be used may be a single compound, or a mixture of positional isomers. In the case where the compound is a mixture of positional isomers, the number of positional isomers in the mixture, the substitution position of substituents in the positional isomers, and a mixing ratio of the positional isomers can be set arbitrarily.

### (Purity)

One of conditions for showing high carrier mobility is that an organic semiconductor material has high purity. Even if trace impurities are contained in an organic semiconductor film, the impurities become a trap for a carrier, or bring a defect to a crystalline structure, which results in causing lowering in mobility. From this point of view, it is desirable that the concentration of impurities is as low as possible, preferably 10% by mass or less, and more preferably 1% by mass or less. The purity of the organic semiconductor material can be checked using, for example, liquid chromatography (HPLC).

### (Specific Preferable Examples)

Specific preferable examples of the compound for use in the second embodiment of the present invention are described below, but the second embodiment of the present invention is not limited to these exemplified compounds. In the following Compounds 1 to 10, a mixture of positional isomers is described as one compound.

In the exemplified compounds, M represents a divalent metal or hydrogen atoms. When M represents a metal, examples of M include a single metal, such as Cu, Zn, Fe, Co, or Ni; and besides a group of atoms for forming a divalent group by bonding to a trivalent or more multivalent metal and other element(s) to each other, such as AlCl, Ti=O, V=O, or SiCl₂. Further, when M is hydrogen atoms, two hydrogen atoms separately bond to any two nitrogen atoms among nitrogen atoms of the isoindole rings and nitrogen atoms of the isoindoline rings.

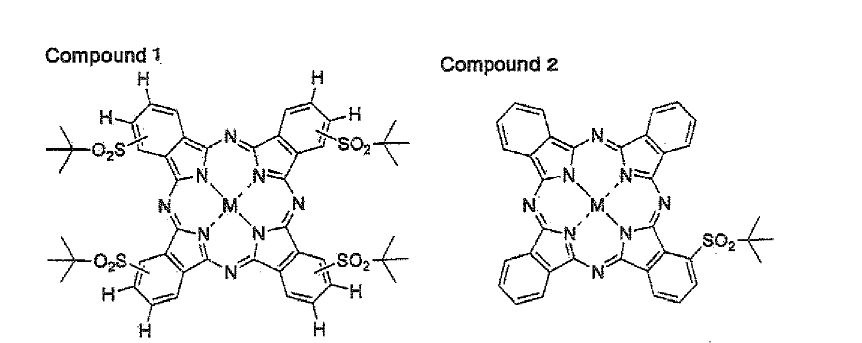

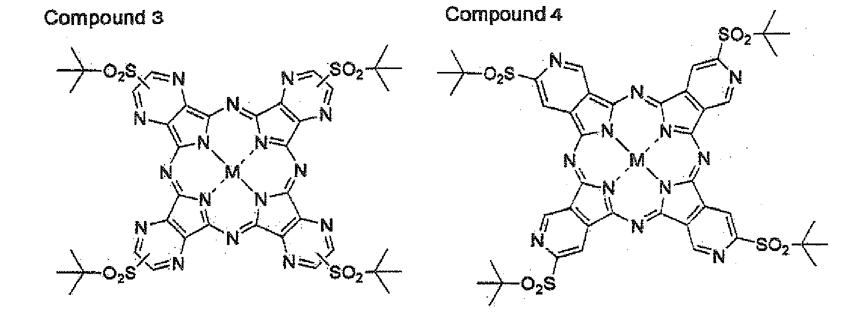

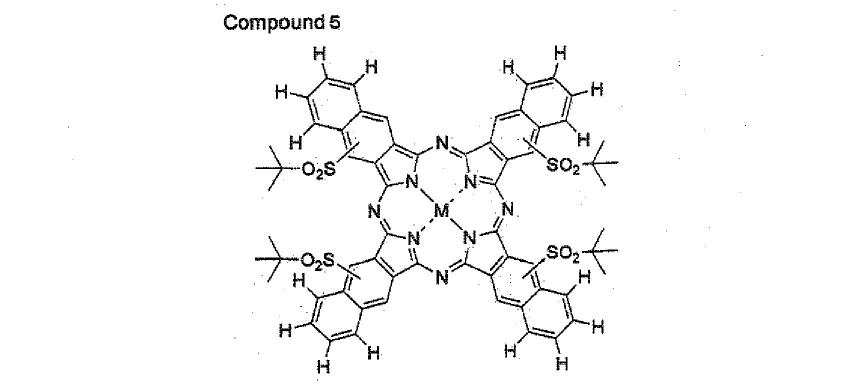

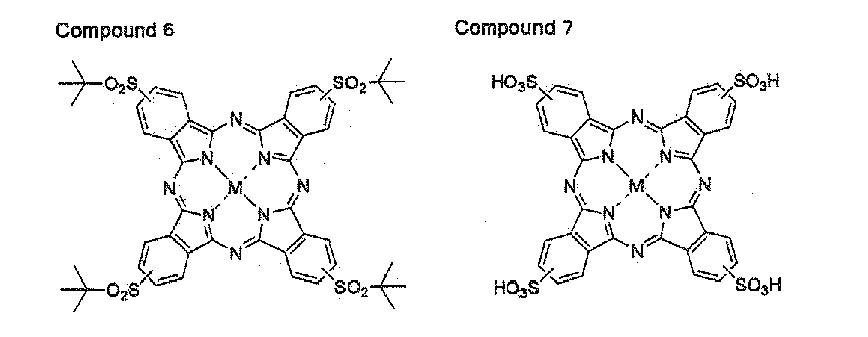

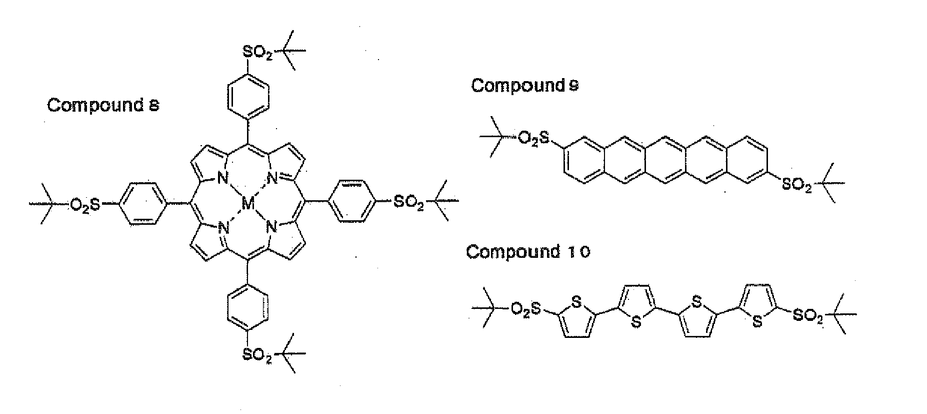

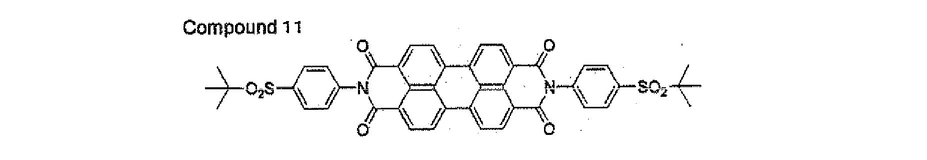

As a result of desubstitution of at least one substituent, Compounds 1, 2, 5, 6, 7, 8, 9, and 10 each are converted to a p-type organic semiconductor, and Compounds 3, 4, and 11 each are converted to an n-type organic semiconductor.

Further, specific preferable examples of the phthalocyanine compound that can be used in the second embodiment of the present invention include the Exemplified compounds (I) to (54), but the second embodiment of the present invention is not limited to those compounds.

### (Synthetic method)

Synthesis of the phthalocyanine compounds can be carried out, according to the methods described, for example, by Hirofusa Shirai, Nagao Kobayashi (editors and authors), "Phthalocyanine -Chemistry and Function-", pp. 1-62, Industrial Publishing & Consulting, Inc. (1997), and Ryo Hirohashi, Kei-ichi Sakamoto & Eiko Okumura (editors), "Phthalocyanine as a functional dye", pp. 29-77, Industrial Publishing & Consulting, Inc. (2004), and JP-A-2005-119165.

Typical examples of the method for synthesizing phthalocyanine compounds include a Weiler method, a phthalonitrile method, a lithium method, a subphthalocyanine method, and a chlorinated phthalonitrile method, as described in the above literatures. Specifically, it is preferable to conduct a phthalocyanine ring-forming reaction using, as a raw material, a compound having a substituent represented by formula (2-I), such as t-butylsulfonylphthalonitrile. In the second embodiment of the present invention, in the phthalocyanine ring-forming reaction, there is no particular limitation to reaction conditions. In the ring-forming reaction, it is preferable to add various kinds of metals that act as central metals in the phthalocyanine. Alternatively, after synthesizing a phthalocyanine compound free from any central metal, a desired metal may be introduced to the phthalocyanine compound. As a reaction solvent, there is no particular limitation, but a high boiling point solvent is preferable. Beside, an acid or a base may be used to accelerate a ring-forming reaction. Optimum reaction conditions are different depending on the structure of a target phthalocyanine compound, but they can be determined in reference to specific reaction conditions as described in the above literatures.

As raw materials that can be used in the synthesis of the phthalocyanine compound, use may be made of phthalic acid anhydride, phthalimide, phthalic acid and a salt thereof, phthalic acid diamide, phthalonitrule, 1,3-diiminoisoindoline, and derivatives thereof. These raw materials are properly substituted by the substituents represented by formula (2-1) as needed, and a synthesis according to the synthetic method described in the above paragraphs may be performed, to obtain the phthalocyanine compounds. Further, the raw materials substituted by the substituents represented by formula (2-I) may be synthesized by any known method. Specifically, for example, 3-t-butylsulfonylphthalonitrile and a metal salt that functions as a central metal source is heated in butanol in the presence of DBU (1,8-diazabicyclo[5.4.0]-7-undecene), to obtain Exemplified compound 1.

Further, compounds, for use in the second embodiment of the present invention, having π-conjugated compound skeletons other than the phthalocyanine compound, can be produced with reference to the descriptions on pages 159 to 228 of "Organic Field-Effect Transistors" (CRC Press, published in 2007), literatures referred to therein, or the like.

### (Film Formation Process)

In the second embodiment of the present invention, first, a film is formed from a compound having the substituent represented by formula (2-I) on a substrate.

### (Substrate)

In the second embodiment of the present invention, examples of the material of the substrate that can be used, include a variety of materials, for example, polyester films, such as polyethylenenaphthalate (PEN) or polyethyleneterephthalate (PET), and other materials, such as polyimide films, ceramics, silicon, quartz, or glass. Further, any substrate may be selected in accordance with intended purposes. For example, a flexible substrate may be used for an application to a flexible device. The thickness of the substrate is not particularly limited.

### (Film Formation Method)

In the second embodiment of the present invention, the method of forming a film of the compound of the substrate is not particularly limited, but the film formation performed by a solution process is preferable in particular.

Herein, the term "film formation performed by a solution process" refers to a film-forming method which includes dissolving an organic compound in a solvent capable of dissolving the organic compound, and applying the resultant solution on a substrate, and then drying. As specific examples, use may be made of any usual method, such as a cast method, a blade coating method, a wire bar coating method, a splay coating method, a dip (immersion) coating method, a bead coating method, an air knife coating method, a curtain coating method, an inkjet coating method, a spin coating method, and a Langmuir-Blodgett (LB) method. In the second embodiment of the present invention, it is more preferable to use a cast method, a spin coat method, or an inkjet method. These solution processes make it possible to produce a large-size organic semiconductor film having a flat surface with a low coat.

### (Coating conditions)

In the case of forming a film on a substrate by the solution process, a coating liquid is prepared by dissolving or dispersing the material to form the film in an appropriate organic solvent (e.g., a hydrocarbon-based solvent, such as hexane, octane, decane, toluene, xylene, ethylbenzene, 1-methylnaphthalene, or 1,2-dichlorobenzene; a ketone-based solvent, such as acetone, methyl ethyl ketone, methyl isobutyl ketone, or cyclohexanone; a halogenated hydrocarbon-based solvent, such as dichloromethane, chloroform, tetrachloromethane, dichloroethane, trichloroethane, tetrachloroethane, chlorobenzene, dichlorobenzene, or chlorotoluene; an ester-based solvent, such as ethyl acetate, butyl acetate, or amyl acetate; an alcohol-based solvent, such as methanol, propanol, butanol, pentanol, hexanol, cyclohexanol, methyl cellosolve, ethyl cellosolve, or ethylene glycol; an ether-based solvent, such as dibutyl ether, tetrahydrofuran, dioxane, or anisole; a polar solvent, such as N,N-dimethylformamide, N,N-dimethylacetamide, 1-methyl-2-pyrrolidone, 1-methyl-2-imidazolidinone, or dimethyl sulfoxide) and/or water, and the coating liquid thus prepared can be utilized in forming of the thin film by various coating methods.

The concentration of the compound for use in the second embodiment of the present invention in such a coating liquid is preferably 0.1 to 80 mass%, more preferably 0.1 to 10 mass%, and the film can be formed with an arbitrary thickness.

Further, in the film formation, a resin binder may be also used. In this case, a thin film can be formed, by dissolving or dispersing a layer-forming material and the resin binder in a suitable solvent described above, to prepare a coating liquid, and coating with the resultant coating liquid according to various coating methods. Examples of the resin binder include insulating polymers, such as polystyrene, polycarbonate, polyarylate, polyester, polyamide, polyimide, polyurethane, polysiloxane, polysulfone, polymethyl methacrylate, polymethyl acrylate, cellulose, polyethylene, and polypropylene; and copolymers of these polymers; photoconductive polymers, such as polyvinyl carbazol and polysilane, and electrically conductive polymers, such as polythiophen, polypyrrole, polyaniline, and polyparaphenylenevinilene. The resin binder may be used singly or, alternatively two or more kinds of the resin binders may be used in combination. Taking the mechanical strength of the thin film into consideration, preferred are resin binders high in glass transition temperatures, and taking the charge transfer degree into consideration, preferred are resin binders containing no polar group, or photoconductive polymers and electrically conductive polymers.

It is preferable in characteristics of the resultant organic semiconductor not to use any resin binder, but the resin binder may be used according to the purposes. In that case, an amount of the resin binder to be used is not particularly limited, but preferably the binder is used from 0.1 to 30% by mass, based on the organic semiconductor film according to the second embodiment of the present invention.

A blend film comprised of a plurality of materials may be formed by coating with a mixed solution to which the compound for use in the second embodiment of the present invention is added with other kind of semiconductor material or additive, according to the intended purposes. For example, when a photoelectric conversion layer is produced, it is preferable to use a mixed solution of the compound for use in the second embodiment of the present invention together with other kind of semiconductor material. As the aforementioned other kind of semiconductor material to be used, it is preferable to mix a compound for use in the second embodiment of the present invention together with a compound having a different polar character from the polar character (p-type, n-type) after desubstitution of the substituent from the compound to be used in the second embodiment of the present invention.

When the aforementioned other semiconductor material to be mixed is a p-type material, any materials of organic semiconductor materials or inorganic semiconductor materials may be used, so long as the material shows hole transporting properties. Preferably, the p-type material is selected from p-type π-conjugated polymers. (for example, polythiophene, polyselenophene, polypyrrol, polyparaphenylene, polyparaphenylenevinylene, polythiophenevinylene, and polyaniline, each of which of is substituted or unsubstituted), condensed polycyclic compounds (for example, anthracene, tetracene, pentacene, anthradithiophene, and hexabenzocoronene, each of which of is substituted or unsubstituted), triarylamine compounds (for example, m-MTDATA, 2-TNATA, NPD, TPD, mCP, CBP), 5-membered hetero-ring compounds (for example, substituted or unsubstituted oligothiophene, TTF), phthalocyanine compounds (phthalocyanine, naphthalocyanine, anthracyanine, and tetrapyrazinopozphylazine, each of which of is a substituted or unsubstituted compound containing any of various metals as a central metal), porphyrin compounds (a substituted or unsubstituted porphyrin containing any of various metals as a central metal), or p-type inorganic semiconductors (for example, inorganic oxides, e.g. Si₁₋ₓCₓ (0≤X≤1), CuI, CuS, GaAs, ZnTe, Cu₂O, Cu₂S, CuSCN, CuF, CuCl, CuBr, CuInSe₂, CuInS₂, CuAlSe₂, CuGaSe₂, CuGaS₂, GaP, NiO, CoO, FeO, Bi₂O₃, MoO₂, or Cr₂O₃). Among these materials, more reference is given with any of p-type π-conjugated polymers, condensed polycyclic compounds, triarylamine compounds, 5-membered hetero-ring compounds, phthalocyanine compounds, or porphyrin compounds; and further reference is given with any of p-type π-conjugated polymers.

When the aforementioned other semiconductor material to be mixed is a n-type material, any materials of organic semiconductor materials or inorganic semiconductor materials may be used, so long as the material shows hole transporting properties. Preferably, the material is selected from fullerene compounds, electron-deficiency phthalocyanine compounds, naphthalene tetracarbonyl compounds, perylene tetracarbonyl compounds, TCNQ compounds, n-type π-conjugated polymers, or n-type inorganic semiconductors. Among these materials, more reference is given with any of fullerene compounds, electron-deficiency phthalocyanine compounds, naphthalenetetracarbonyl compounds, perylenetetracarbonyl compounds, or n-type π-conjugated polymers; and particular reference is given with any of fullerene compounds or n-type π-conjugated polymers. In the second embodiment of the present invention, the fullerene compound refers to a substituted or unsubstituted fullerene, and may be any of C₆₀, C₇₀, C₇₆, C₇₈, C₈₀, C₈₂, C₈₄, C₈₆, C₈₈, C₉₀, C₉₆, C₁₁₆, C₁₈₀, C₂₄₀, C₅₄₀, or the like. Among these fullerene compounds, a substituted or unsubstituted C₆₀, C₇₀, or C₈₆ is preferable, and PCBM ([6, 6]-phenyl-C₆₁-butyric acid methyl ester) and analogs thereof are especially preferable. Examples of the PCBM analogs include PCBMs which have C₇₀, C₈₆, or the like substituted for the portion of C₆₀, which have other aromatic rings or hetero rings substituted for the benzene ring in the substituent; or which are n-butyl ester, iso-butyl ester, or the like substituted for the methyl ester. Examples of the electron-deficiency phthalocyanines include anthracyanines, napththalocyanines, and phthalocyanines, each of which contain various central metals, and to which four or more electron-withdrawing groups are bonded (for example, F₁₆MPc, FPc-S8), and substituted or unsubstituted tetrapyrazinoporphylazines. The naphthalene tetracarbonyl compound is not particularly limited, and is preferably naphthalene tetracarboxylic acid anhydride (NTCDA), naphthalene bisimide compounds (NTCDI), or perinone dyes (for example, Pigment Orange 43 (PO43), Pigment Red 194). The peryrene tetracarbonyl compound is not particularly limited, and is preferably peryrene tetracarboxylic acid anhydride (PTCDA), peryrene bisimide compounds (PTCDI), or benzimidazole-condensed peryrene (PV). The TCNQ compound refers to a substituted or unsubstituted TCNQ, and TCNQ derivatives in which a benzene ring portion is replaced with another aromatic ring or hetero ring, and examples of the TCNQ compound include TCNQ, TCAQ, and TCN3T. The inorganic semiconductor may be any materials, so long as the material shows electron transporting properties, and examples of the inorganic semiconductor include TiO₂, TiSrO₃, ZnO, Nb₂O₃, SnO₂ ,WO₃, Si, SiO, CdS, CdSe, V₂O₅, ZnS, ZnSe, SnSe, KTaO₃, FeS₂, PbS, InP, CraAs, CuInS₂, CuInSe₂, LiF, and CaF. Especially preferable examples of the n-type organic semiconductor material are set forth below.

In the following formula, R is not particularly limited, but is preferably any of a hydrogen atom, a substituted or unsubstituted, branched or straight alkyl group (those having carbon atoms of preferably from 1 to 18, more preferably from 1 to 12, and further preferably from 1 to 8), a substituted or unsubstituted aryl group (those having carbon atoms of preferably from 6 to 30, more preferably from 6 to 20, and further preferably from 6 to 14).

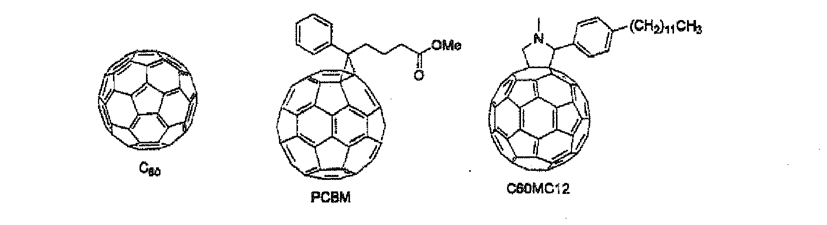

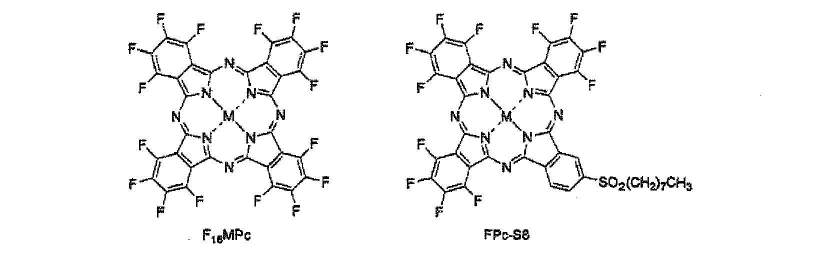

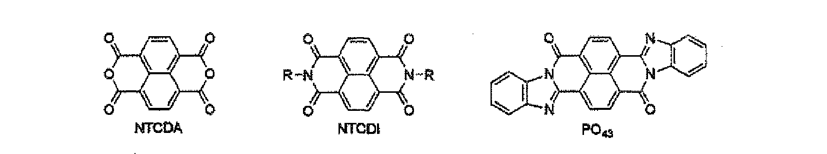

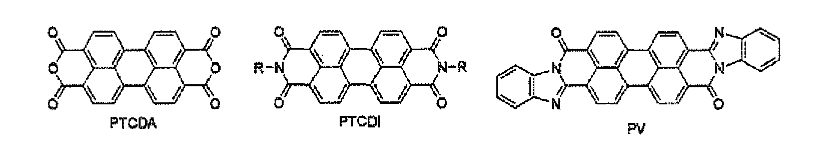

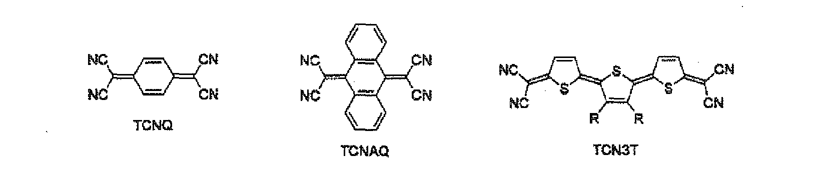

When a mixed solution of plural kinds of materials is used, a proportion of the compound for use in the second embodiment of the present invention is preferably from 10 to 99.9% by mass, more preferably from 20 to 99% by mass, and further preferably from 30 to 99% by mass, in the whole materials to be mixed.

Further, in the film formation, a substrate may be heated or cooled. It is possible to control film qualities or packing state of molecules in the film, by changing a temperature of the substrate. The substrate temperature, though not particularly limited, is preferably from -200 °C. to 400 °C, more preferably from -100°C to 300°C, and further preferably from 0 °C to 200 °C.

The π-conjugated compound for use in the second embodiment of the present invention, which has the substituent represented by formula (2-1), is suitable for the film formation according to a solution process in particular. In the second embodiment of the present invention, although it is possible to form a film according to a vacuum process, for example, a physical vapor deposition method, such as a vacuum deposition method, a spattering method, an ion-plating method, or a molecular beam epitaxy (MBE) method, or a chemical vapor deposition (CVD) method, such as plasma polymerization, these vacuum processes are not preferable since they are high in production costs and are poor in flatness of the resultant film surface. Further, in order to form a film according to a solution process, it is necessary that materials be dissolved in the above-described solvents or the like, but the requirement for the solution process is not satisfied only by dissolving the materials. Generally, even a material for film formation according to a vacuum process can be dissolved in a solvent at some level. However, after dissolving a material in a solvent and then coating with the resultant solution in the solution process, there is a process of forming a thin film by evaporating the solvent. In this connection, many of the materials being unsuitable for the solution process have high crystallinity. Thus, these materials are crystallized in this process, and it is difficult to form a thin film of good quality. In contrast, the π-conjugated compound for use in the second embodiment of the present invention, which has the substituent represented by formula (2-I), hardly causes such crystallization, and the π-conjugated compound is also excellent in this point.

A coating amount of a solution containing the above-described compound varies depending on the kind of a solvent and the concentration of the solution, but the coating amount is appropriately determined so that a film thickness of the thus-formed organic semiconductor film would be within the range described below.

### (Desubstitution Step)

After forming the film of the π-conjugated compound having the substituent represented by formula (2-1) on a substrate, the compound is subjected to desubstitution, to release the substituent from the compound.

The desubstitution reaction to release the substituent represented by formula (2-1) can be caused by heating preferably at 150 °C or higher, more preferably at 200 °C or higher, and further preferably at 250 °C or higher. The upper limit of heating temperature is preferably 500 °C. or lower, more preferably 450 °C or lower, and further preferably 400 °C or lower. The higher the temperature is, the shorter the reaction time is. The lower the temperature is, the longer the time required for the desubstitution reaction is.

It is possible to subject the target compound to desubstitution of not all but a part of the substituents represented by formula (2-1), by changing the heating temperature and/or the heating time according to the applications of the organic semiconductor film, thereby making it possible to control properties (for example, mobility) of the organic semiconductor film. A proportion of desubstitution of the substituents represented by formula (2-1) is preferably from 30 to 100%, more preferably from 40 to 100%, and further preferably from 50 to 100%.

As for the heating, in addition to heating by heat transfer using a heater, heating may be conducted by use of an infrared ramp, or a method of irradiating a light having a wavelength which a target compound absorbs. Further, the heating may be conducted by providing a light-absorbing layer in the vicinity of the film of the π-conjugated compound having the substituent represented by formula (2-I), and absorbing light by the light-absorbing layer. The heating is preferably conducted under the inactive atmosphere, such as nitrogen gas or argon gas, in vacuum, or the like.

### (Organic Semiconductor Material)

The term "organic semiconductor material" in the second embodiment of the present invention means an organic material exhibiting semiconductor characteristics. Similar to semiconductors composed of inorganic materials, there are p-type organic semiconductors conducting positive holes as carriers, and n-type organic semiconductors conducting electrons as carriers. The flowability of the carrier in the organic semiconductor is expressed as carrier mobility µ. Mobility is, in general, favorably as high as possible, and it is preferably 10⁻⁷ cm²/Vs or higher, more preferably 10⁻⁶ cm²/Vs or higher, and further preferably 10⁻⁵ cm²/Vs or higher, though it may change depending on the intended uses. Mobility can be determined by characteristics of the produced field-effect transistor (FET) device, or by the time of flight (TOF) method.

### (Post Treatment of Organic Semiconductor Film)

Properties of the thus-produced organic semiconductor film can be controlled by a post treatment. For example, morphology of the film or state of packing of molecules in the film can be altered, by a heat treatment or exposure to a solvent vapor, to improve characteristics of the film. Further, an oxidation or reduction reaction can be taken place, by exposing to an oxidizing or reducing gas or solvent, or other substance, or mixing with any of these materials, to control the carrier density in the film,

### (Film Thickness)

The film thickness of the organic semiconductor film is not particularly limited, and varies depending on the kind or the like of the electronic devices to be used, but the film thickness is preferably from 5 nm to 50 µm, more preferably from 10 nm to 5 µm, and further preferably from 20 nm to 500 nm.

### (Organic Electronic Device)

The organic electronic device of the second embodiment of the present invention contains the organic semiconductor film obtained by the above-described method. Herein, the organic electronic device means: a device that contains an organic semiconductor and two or more electrodes and that is capable of controlling an electric current flowing between the electrodes or a voltage caused therewith by means of electricity, light, magnetism, chemical substances, or the like; or alternatively a device that is capable of generating light, an electric field, a magnetic field, or the like by the applied voltage or electric current. Examples of the organic electronic device include organic photoelectric conversion devices, organic field-effect transistors, organic electroluminescence devices, gas sensors, organic rectifier devices, organic inverters, and information-recording devices. The organic photoelectric conversion devices can be applied to any of photo-sensor use and energy-conversion use (e.g. solar cells). Among those devices, preferable uses are organic field-effect transistors, organic photoelectric conversion devices, and organic electroluminescence devices; more preferably organic field-effect transistors, and organic photoelectric conversion devices; and particularly preferably the organic field-effect transistors.

### (Organic field-effect transistors)

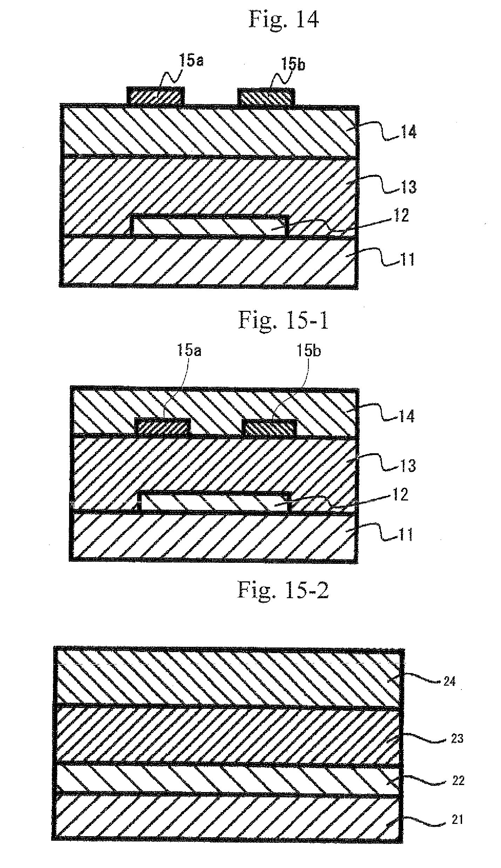

A device configuration of the organic field-effect transistor that is one preferable embodiment of the organic electronic device according to the second embodiment of the present invention, is described with reference to Fig. 14.

Fig. 14 is a sectional view schematically illustrating an example of structure of the organic field-effect transistor using the organic semiconductor film of the second embodiment of the present invention. The transistor shown in Fig. 14 has a laminate structure as a basic structure. As an undermost layer, there is arranged a substrate 11 (for example, polyester films such as polyethylenenaphthalate (PEN) and polyethyleneterephthalate (PET), polyimide films, ceramics, silicon, quartz, and glass). An electrode 12 is arranged at a portion of the upper surface of the substrate. Further, an insulator layer 13 is provided so as to cover said electrode therewith, and also to contact with the substrate 11 at a portion other than the electrode 12. Further, an organic semiconductor layer 14 is provided on an upper surface of the insulator layer 13, and moreover, at a portion of the upper surface of the organic semiconductor layer, there are arranged two electrodes 15a and 15b isolating from each other.

The constituent materials of the electrodes 12, 15a, and 15b are not particularly limited as long as they exhibit electrical conductivity, and may be any of known conductive materials, including metal materials, such as Cr, Al, Ta, Mo, Nb, Cu, Ag, Au, Pt, Pd, In, Ni or Nd, alloy materials thereof, carbon materials, and electro-conductive polymers. The structure shown in Fig. 14 is called as a top contact-type device. Besides, use may be preferably made of bottom contact-type device in which the two electrodes 15a and 15b are arranged beneath the organic semiconductor layer 14, as shown in Fig. 15-1.

The gate width (channel width) W and the gate length (channel length) L are not particularly limited, but the ratio of W to L is preferably 10 or more, and more preferably 20 or more.

There is no particular limitation to the thickness of each layer, but if thinner transistors are required, for example, the whole thickness of the transistor is preferably set to from 0.1 to 0.5 µm. For achieving such a thickness, the thickness of each layer is preferably set to from 10 to 400 nm, and the thickness of each electrode is preferably set to from 10 to 50 nm.

Though, there is no particular limitation to the material constituting the insulator layer 13 as long as obtaining required insulating effect, examples thereof include silicon dioxide, silicon nitride, polyester insulating materials, polycarbonate insulating materials, acrylic polymer-based insulating materials, epoxy resin-based insulating materials, polyimide insulating material, and polyparaxylylene resin-based insulating materials. The insulator layer 13 may have a surface-treated upper surface, and preferable example thereof include an insulator layer having a silicon dioxide surface coated with hexamethyldisilazane (HMDS) or octadecyltrichlorosilane (OTS).

### (Sealing)

For the sake of protecting the device from the air and moisture to improve the storage stability of the device, the whole device may be sealed with a metal sealing can, glass, an inorganic material, such as alumina or silicon nitride, or a polymer material, such as parylene.

### (Organic photoelectric conversion device)

Fig. 15-2 is a cross-sectional view schematically showing a structure of a typical organic photoelectric conversion device using the organic semiconductor material of the second embodiment of the present invention. The device of Fig. 15-2 has a multi-layer structure, in which a substrate 21 is disposed as the lowest layer, an electrode layer 22 is provided thereon, an organic photoelectric conversion layer 23 composed of the organic semiconductor film obtained by the above-described method is provided thereon, and an electrode layer 24 is disposed thereon, in this order. Between the electrode layer 22 or 24 and the organic photoelectric conversion layer 23, there may be disposed an additional layer(s), such as a buffer layer capable of enhancing smoothness of the surface, a carrier-injecting layer capable of accelerating injection of holes or electrons from the electrode, a carrier-transporting layer capable of transporting the holes or electrons, or a carrier-block layer capable of blocking the holes or electrons, each of which is not shown in Fig. 15-2, and one layer of those may also act as another layer(s). In the second embodiment of the present invention, these layers that are disposed between the electrode layer and the photoelectric conversion layer are all described as a buffer layer irrespective of their functions. Further, the electrode layer and other layers are not necessarily flat, but may have a large irregularity, or a three dimensional shape (for example, comb shape).

The material for use in the substrate 21 is not particularly limited, as long as the material transmits a visible light or an infrared light. The transmittance of the visible light or infrared light is preferably 60% or more, more preferably 70% or more, and most preferably so% or more. Examples of the material include polyester films, such as polyethylene naphtalate (PEN) or polyethylene terephthalate (PET); polyimide films, ceramic, silicon, quartz, and glass. The thickness of the substrate is not particularly limited.

The material for use in the electrode layer 22 is not particularly limited, so long as the material transmits a visible or infrared light and shows electrical conductivity. The transmittance of the visible or infrared light is preferably 60% or more, more preferably 70% or more, most preferably 80% or more. Preferable examples of such a material include transparent electrically conductive oxides, such as ITO, IZO, SnO₂, ATO (antimony-doped tin oxide), ZnO, AZO (Al-doped zinc oxide), GZO (gallium-doped zinc oxide), TiO₂, and ITO (fluorine-doped tin oxide). Of these oxides, ITO and IZO are especially preferred from the viewpoints of process suitability and smoothness. The thickness is not particularly limited, but it is preferably 1 nm to 200 nm, and more preferably 5 nm to 100 nm. When the electrode 22 has a structural independency, the substrate 11 is not necessary. When the electrode 22 also acts as a substrate 21, the film thickness may be thicker than that described above.

As for the material for forming the photoelectric conversion device, the compound for use in the second embodiment of the present invention (or a compound in which a part or all of the substituents has already desubstituted from the compound for use in the second embodiment of the present invention) may be used singly, or in combination with other semiconductor material(s). It is preferable to use the compound in combination with other semiconductor material(s). The components and the composition in the case where the compound is used in combination with other semiconductor material(s) are the same as described above.

As for the material for use in the buffer layer, any of organic or inorganic materials may be used, so long as the material has a carrier transporting capacity, and an amorphous material is preferable. As a hole transporting buffer material, use may be preferably made of any material may be used, but any of conductive polymers (for example, PEDOT:PSS), p-type π-conjugated polymers, triarylamine compounds, and p-type inorganic semiconductor; and more preferably any of conductive polymers and triarylamine compounds. As an electron transporting buffer material, any material may be used, and preferably any of fullerene compounds, electron-deficiency phthalocyanine compounds, naphthalene tetracarbonyl compounds, perylenetetracarbonyl compounds, n-type π-conjugated polymers, metal complex compounds (for example, Alq, BAlq), Bathocuproine, and n-type inorganic semiconductors; more preferably any of naphthalenetetracarbonyl compounds, metal complex compounds, Bathocuproine, and n-type inorganic semiconductors.

The material for use in the electrode layer 24 is not particularly limited, so long as the material shows electric conductivity. From the viewpoint of enhancing the light utilization efficiency, highly light-reflective materials are preferably used. Of such materials, Al, Pt, W, Au, Ag, Ta, Cu, Cr, Mo, Ti, Ni, Pd and Zn are preferred; and Al, Pt, Au and Ag are more preferred. The thickness of the electrode layer 24 is not particularly limited, but it is preferably 1 nm to 1 µm, and more preferably 5 nm to 500 nm.

For enhancement of the storage stability of the device, it is preferable that the device is sealed so that the device can be held in an inert atmosphere. Examples of a preferable sealing material include inorganic materials, such as metals, glass, silicon nitride, or alumina, and organic materials, such as parylene. When the device is sealed, an agent, such as a desiccant, may be encapsulated.

The organic thin-film photoelectric conversion device of the second embodiment of the present invention may be used for energy conversion use (thin-layer organic solar cell), or as an optical sensor (for example, solid-state image sensor). When used for energy conversion, the organic thin-film photoelectric conversion device of the second embodiment of the present invention may be used singly, or alternatively it may be used with other organic thin-film photoelectric conversion device(s) in a laminated structure (tandem). A method of using them in tandem is described in detail in Applied Physics Letters, 2004, 85, p. 5757-5759, which may be used for reference. When the organic thin-film photoelectric conversion device of the second embodiment of the present invention is used as an optical sensor, it is preferable that a bias is applied between the electrodes 12 and 14 to read a signal so that S/N ratio is improved. In this embodiment, it is preferable that the bias to be applied to the photoelectric conversion layer is in the range of 1.0 × 10⁵ V/cm to 1.0 × 10⁷ V/cm. Solid-state image sensors using organic thin-film photoelectric conversion devices are described in detail in, for example, JP-A-2003-234460, JP-A-2003-332551, and JP-A-2005-268609, each of which may be used for reference.

By using the π-conjugated compound having a substituent represented by formula (2-1) as a precursor of the organic semiconductor, film formation on a substrate can be easily performed, and the desubstitution reaction to release the substituent efficiently undergoes by applying an external stimulation, such as heat, to the thus-formed film. As a result, the organic semiconductor film can be obtained, which shows favorable semiconductor properties, such as high chemical stability and high stability of semiconductor performance. The organic semiconductor film of the second embodiment of the present invention and the electronic devices (especially the organic field-effect transistor (FET), the photoelectric conversion device) using the organic semiconductor film each are high in purity and show favorable semiconductor properties, such as high stability of semiconductor performance.

The present invention is contemplated for providing a method for producing a desubstituted compound having high industrial applicability, in which a solvent-soluble precursor compound that can respond favorably to a solution process is used, and each of the precursor compound and a target compound obtained by applying an external stimulation to the precursor compound show favorable storage stability. Further, the present invention is contemplated for providing a method for producing efficiently pigment fine-particles, phthalocyanine compounds, and thin films of these materials, each having excellent properties, by using the above desubstitution technique.

According to the method of the present invention for producing a desubstituted compound, it is possible to respond favorably to a solution process on account of using a solvent-soluble precursor compound as a raw material. In addition, the production method of the present invention makes it possible to undergo rapidly the desubstitution reaction to release the substituent by applying an external stimulation to the precursor compound, to obtain a target compound. Further, the production method of the present invention exhibits excellent advantageous effects, such that both the precursor compound and the target compound obtained by applying an external stimulation to the precursor compound show high storage stability, such as light resistance, thereby enabling storage of each of the raw material and the product, and enhancing freedom of the production process, and making the production more efficient, and moreover realizing high quality. Further, this technique makes it possible to produce efficiently pigment fine-particles, phthalocyanine compounds, and thin films of these materials, each at high purity and having excellent properties.

Further, the present invention has been made in consideration of the above-described technical background. The present invention is contemplated for providing an organic semiconductor film obtained by using a compound having a specific substituent, the compound showing favorable semiconductor properties, such that the compound has a solubility to a solvent suitable for production of a device in a solution process, and yet after the film production from the compound, high chemical stability and high stability of semiconductor performance are exhibited. Further, the present invention is contemplated for providing a production method of the organic semiconductor film, and organic electron devices using the organic semiconductor film.

According to the method of the present invention, it is possible to carry out film production by a solution process, and to produce efficiently with a low cost organic semiconductor films showing favorable semiconductor properties including high chemical stability and high stability of semiconductor performance.

The organic semiconductor film of the present invention and the electronic device (especially the organic field-effect transistor (FET)) using the organic semiconductor film each show favorable semiconductor properties on account of high purity and high stability of semiconductor performance.

### EXAMPLES

The present invention will be described in more detail based on the following examples, but the invention is not intended to be limited thereto.

### <Examples 1>

Exemplified compound (1) (the compound in which M represents Cu) [or Compound 1a (the compound in which M represents Cu in the Compound 1)] was produced according to the synthesis of dye compound (I-1) described in JP-A-2005-119165. This Exemplified compound (1) was soluble in a solvent such as chloroform.

The thus-produced Exemplified compound (1) was heated at the predetermined temperature, and changes of molecular weight and crystalline structure between before and after heating were each measured as described below.

### (TG/ATA Measurement)

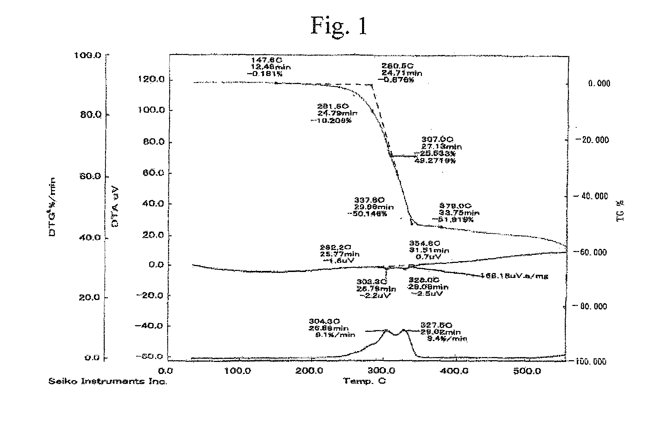

The thermal analysis (TG/DTA measurement) of the thus-produced Exemplified compound (1) was conducted. The TG/DTA measurement was conducted at the rate of temperature increase of 10 °C/min in a range of 30 °C to 550 °C under a current of nitrogen gas (flow rate: 200 ml/min) using EXSTAR 6000 (trade name, manufactured by Seiko Instruments Inc.), to determine a rate of decrease in mass. The measurement results are shown in Fig. 1. Fig. 1 is a graph showing TG/DTA measurement results of the Exemplified compound (1). Herein, in each of Examples and Comparative Examples described below, the measurement of TG was conducted using the same apparatus and under the same conditions as described above.

In Fig. 1, the uppermost curve indicates the change of mass with respect to temperature (TG.). The bottom curve indicates the heat going in and out with respect to temperature (enthalpy change) (DTA). The middle curve indicates the amount of change of TG (differential value) per time (DTG).

From the uppermost curve in Fig. 1, it is understood that reduction in mass occurred gradually from a temperature approximately more than 200 °C, and about 50% of reduction in mass occurred up to about 340 °C. This reduction in mass corresponds to the mass content of the substituent (the -SO₂C(CH₃)₃ group) of the Exemplified compound (1). Further, from the bottom curve in Fig. 1, it is understood that endotherm started from about 240 °C and continued up to about 340 °C. From these results, it is understood that the Exemplified compound (1) was desubstituted by heating.

### (MALDI-TOF-MS Measurement)

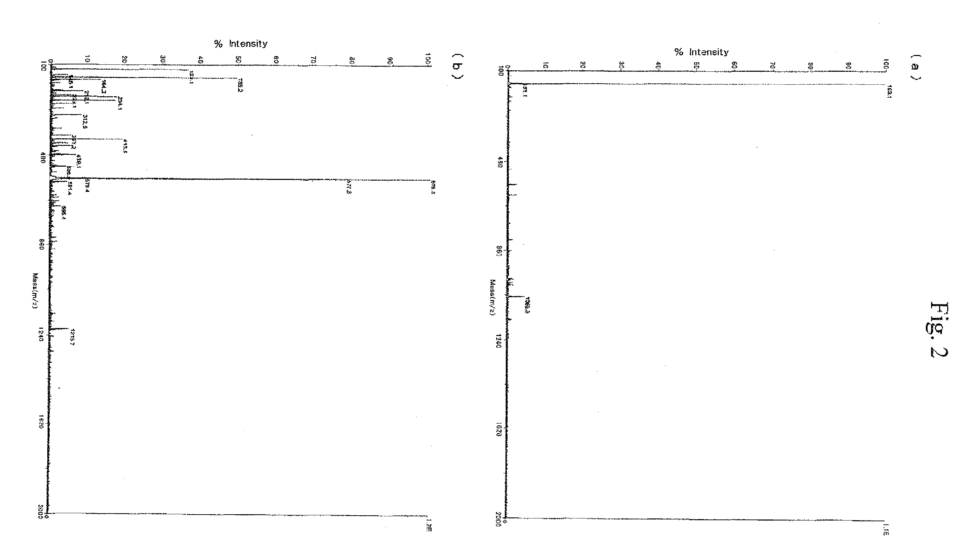

Matrix-Assisted Laser Desorption/Ionization Time-Of-Flight Mass Spectrometry (MALDI-TOF-MS) was conducted respectively with respect to the Exemplified compound (1) before and after heating at the rate of temperature increase of 10 °C/min up to 400 °C under a current of nitrogen gas. For the MALDI-TOF-MS measurement, Voyager-DE PRO (trade name, manufactured by Applied Biosystems) was used and α-cyano-4-hydroxycinnamic acid (a product of Tokyo Chemical Industry Co, Ltd.) was used as a matrix. The measurement was each conducted in positive-mode. The spectrum measurement results are shown in Fig. 2. Fig. 2(a) is a graph showing MALDI-TOF-MS spectrum measurement results of Exemplified compound (1) before heat treatment. Fig. 2(b) is a graph showing MALDI-TOF-MS spectrum measurement results of Exemplified compound (1) after heat treatment.

It was fond that in the Fig. 2(a) showing the state before heat treatment, a peak of 1056 ([M⁺]+1) corresponding to the molecular weight of Exemplified compound (1) appeared, and in contrast, in the Fig. 2(b) showing the state after heat treatment, the peak disappeared and, instead of this peak, a peak of 575 ([M⁺]) corresponding to the molecular weight of unsubstituted cupper phthalocyanine (CuPc : C₃₂H₁₆CᵤN₈) newly appeared. Further, similar results were also obtained when the compound was heated up to 350 °C and 550 °C, respectively. From these results, it is also understood that the Exemplified compound (1) was converted to the unsubstituted cupper phthalocyanine by heating.

### (X-ray Diffraction Measurement)

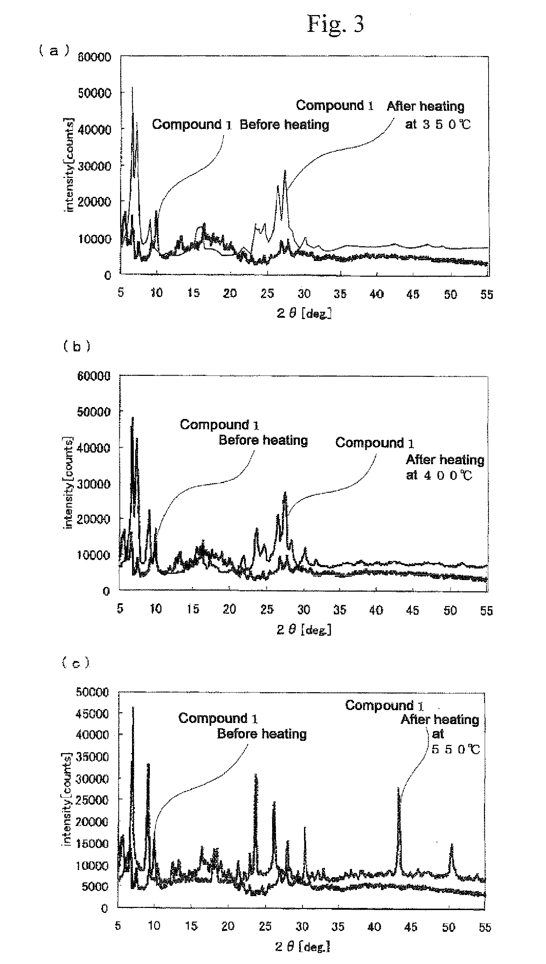

X-ray diffraction measurement was conducted with respect to the Exemplified compound (1) that was heated at the rate of temperature increase of 10 °C/min under a current of nitrogen gas up to 350 °C, 400 °C, or 550 °C, respectively. For X-ray diffraction measurement, X-RAY DIFFRACTOMETER PINT-2500 (trade name, manufactured by Rigaku Corporation) was used. The measurement results are shown in Fig. 3.

As is apparent from the results shown in Fig 3, it is understood that the Exemplified compound (1) that was an amorphous solid before heating was crystallized after the heating up to the respective temperatures. Further, it is understood that the crystalline-system changes as the temperature is raised. Specifically, it is understood that when heated up to 350 °C or 400 °C, the crystalline system was α-type, and in contrast, when heated up to 550 °C, a β-type phthalocyanine compound pigment was formed.

### (Measurement of Change of Heat Quantity)

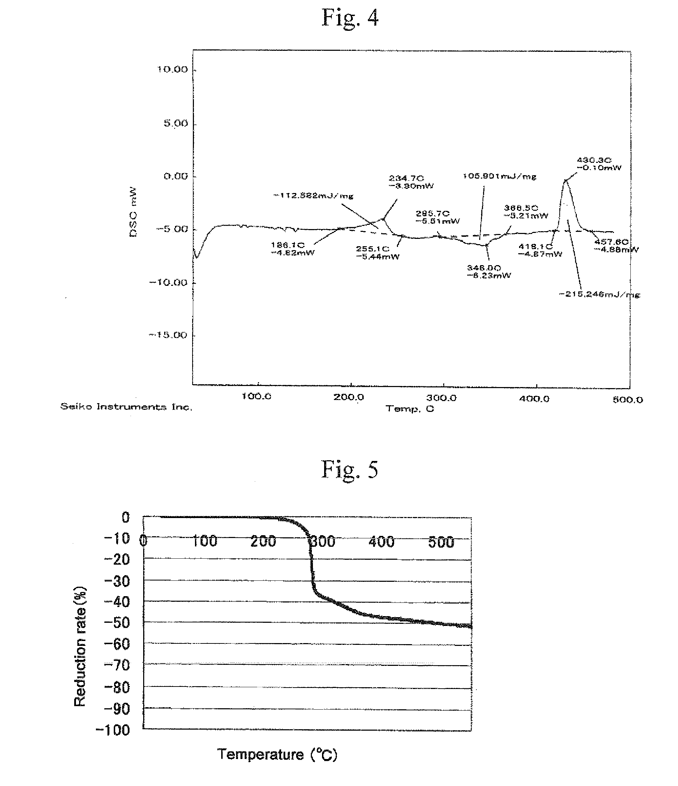

With respect to the Exemplified compound (1), change of heat quantity in the range of the decomposition temperature observed in the above-described TG-DTA measurement was measured by encapsulating a sample in an airtight cell made of SUS and heating the sample at the rate of temperature increase of 10 °C/min in the range of 30 °C to 550 °C., using a DSC instrument: DSC 6200R (trade name, manufacture by Seiko Instrument Inc.). The measurement results are shown in Fig. 4.

As is apparent from the results in Fig 4, an endothemic peak arising from the decomposition of the dye was observed at near 350°C. Further, an exothermic peak was observed at near 430 °C in the range of no reduction in mass. From these results, it is understood that the crystalline system of the Exemplified compound (1) was changed by heating at a temperature near 430 °C from α-type to β-type.

From these measurement results, it is understood that the Exemplified compound (1) (a solvent-soluble precursor compound) was in the state of an amorphous solid, and that the Exemplified compound (1) was converted to a crystalline unsubstituted cupper phthalocyanine (α-type) as a result of desubstitution of the substituent (the -SO₂C(CH₃)₃ group) from the compound by heating, and further, the crystalline system of the cupper phthalocyanine compound was changed at a temperature near 430 °C from the α-type to β-type.

### <Example 2>

6.21 g of α-t-butylsulfonylphthalonitrile was added to 10.5 ml of hexamethyldisilazane and 6.4 ml of dimethylformamide, and further 1.40 g of zinc bromide was added. Thereafter, the resultant mixture was stirred at 100 °C. for 8 hours, and then filtrated with methanol, to obtain 4.00 g of Exemplified compound (51) (or Compound 1b (the compound in which M represents Zn in the Compound 1)). The MS spectrum of the compound indicated 1057 (=[M⁺]+1: positive polarity). The Exemplified compound (51) was soluble in a solvent such as chloroform.

The TG measurement results of the Exemplified compound (51) are shown in Fig. 5.

The thus-obtained Exemplified compound (51) was heated at 400 °C. and a MS spectrum of the residue of the compound was measured. As a result of the measurement, it was found that a peak of the MS spectrum was changed to 576 (=[M⁺]; positive polarity). From these results, it is understood that the Exemplified compound (51) was changed to a zinc phthalocyanine pigment as a result of desubstitution at a temperature near 300 °C.

### <Example 3>

20.0 g of α-t-butylsulfonylphthalonitrile was added to 2.2 g of N,N'-dimethylethylenediamine and 25 ml of N-methylpyrrolidone, and stirred at 160 °C for 8 hours. The resultant mixture was then filtrated with methanol, to obtain 3.50 g of Exemplified compound (52) (or Compound 1c (the compound in which M represents H₂ in the Compound 1)). The MS spectrum of the compound indicated 996 (=[M⁺]+1: positive polarity). The Exemplified compound (51) was soluble in a solvent such as chloroform.

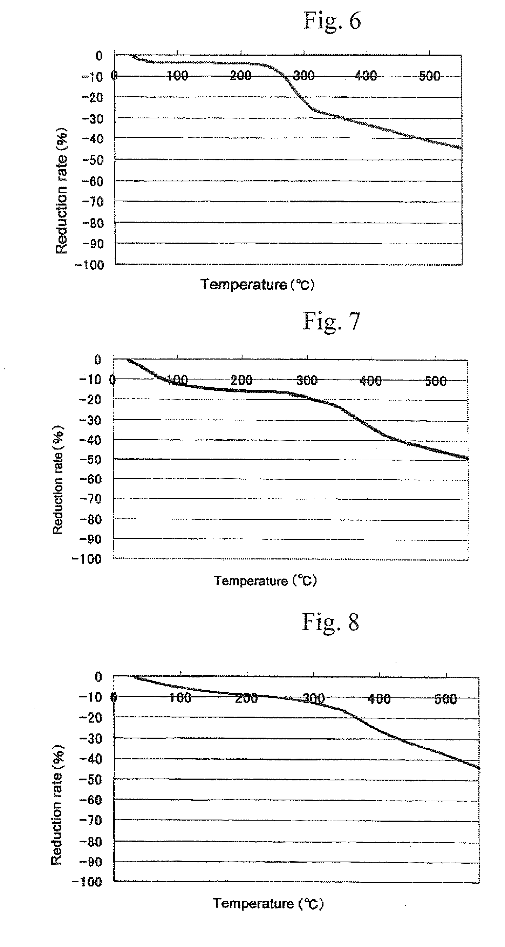

The TG measurement results of the Exemplified compound (52) are shown in Fig. 6.

The thus-obtained Exemplified compound (52) was heated at 400 °C and a MS spectrum of the residue of the compound was measured. As a result of the measurement, it was found that a peak of the MS spectrum was changed to 514 (=[M⁺]: positive polarity). From these results, it is understood that the Exemplified compound (52) was changed to a non-metal (hydrogen-type) phthalocyanine pigment as a result of desubstitution.

It was conformed that the purity of Compound 1a, Compound 1b, and Compound 1c was each 99% or more from the results of liquid chromatography (HPLC; column: TSK-gel ODS-80 Ts (trade name, manufactured by TOSOH CORPORATION), 4.6x150 mm, eluent: THFM₂O=47/53 (AcOH, NEt₃ each 0.1%), detection wavelength: 254 nm and 675 nm).

### <Example 4>

The MS spectrum of zinc phthalocyanine-tetrasulfonic acid (Exemplified compound (53)) (or Compound 7a (the compound in which M represents Zn)) commercially available from Frontier Scientific, Inc. was 895(=[M⁺]: negative polarity). This Exemplified compound (53) was soluble in water.

The TG measurement results of this compound are shown in Fig. 7.

The zinc phthalocyanine-tetrasulfonic acid was soluble in water even after heated at 250 °C. It is considered that the initial reduction in weight in TG arisen from a solvent or water. Thereafter, a MS spectrum of the residue obtained by heating the compound up to 400 °C was measured. As a result, it was found that the peak of the MS spectrum was changed to 576(=[M⁺]: positive polarity). From these results, it is understood that the Exemplified compound (53) was converted to a zinc phthalocyanine pigment as a result of desubstitution of the substituent (the -SO₃H group) from the Exemplified compound (53).

### <Example 5>

The MS spectrum of metal-free phthalocyanine-tetrasulfonic acid (Exemplified compound (54)) (or Compound 7b (the compound in which M represents H₂)) commercially available from Frontier Scientific, Inc. was 832(=[M⁺]-1, negative polarity). This Exemplified compound (54) was soluble in water.

The TG measurement results of this compound are shown in Fig. 8.

The Exemplified compound (54) was soluble in water even after heated at 250 °C. It is considered that the initial reduction in weight in TG arisen from a solvent or water. Thereafter, a MS spectrum of the residue obtained by heating the compound up to 400 °C. was measured. As a result, it was found that the peak of the MS spectrum was changed to 514(=[M⁺]: positive polarity). From these results, it is understood that the Exemplified compound (54) was converted to a non-metal (hydrogen-type) phthalocyanine pigment as a result of desubstitution from the Exemplified compound (54).

### <Example 6>

MALDI-TOF-MS measurement was conducted respectively with respect to the Compound 1b, Compound 1c, Compound 7a, and Compound 7b, before and after heating up to 400 °C., in the same manner as the Compound 1a. Before the heating, peaks of 1057 ([M+H]⁺), 994 (M⁺), 896 (M⁺), and 834 (M⁺) corresponding to the respective molecular weight of these compounds were observed. In contrast, after the heating, all of those peaks disappeared, and instead of these, new peaks of 576 (corresponding to the molecular weight of ZnPc: C₃₂H₁₆N₈Zn), 514 (corresponding to the molecular weight of H₂Pc: C₃₂H₁₈N₈), 576 (corresponding to the molecular weight of ZnPc: C₃₂H₁₆N₈Zn), and 514 (corresponding to the molecular weight of H₂Pc: C₃₂H₁₈N₈) were measured, respectively.

From these results, it is understood that the Compound 1b, Compound 1c, Compound 7a, and Compound 7b were converted to unsubstituted ZnPc, H₂Pc, ZnPc, and H₂Pc, respectively, as a result of desubstitution of the respective substituent from these compounds, in the same manner as the Compound 1a.

### <Example 7>

### (Production of Thin Film 1)

2 g of Exemplified compound (1) (a solvent-soluble precursor compound) was added to 100 ml of chloroform and dissolved therein, to prepare a dye precursor-containing coating liquid. The thus-prepared dye precursor-containing coating liquid was coated on a 1.0-mm thick glass plate under the conditions of 23°C. and 50% R.H. according to a spin coat process while changing revolutions from 500 to 1000 rpm, to produce a dye film (thin film 1). The organic film produced at this point was observed under a polarizing microscope and an electronic microscope, and formation of a uniform amorphous film was confirmed.

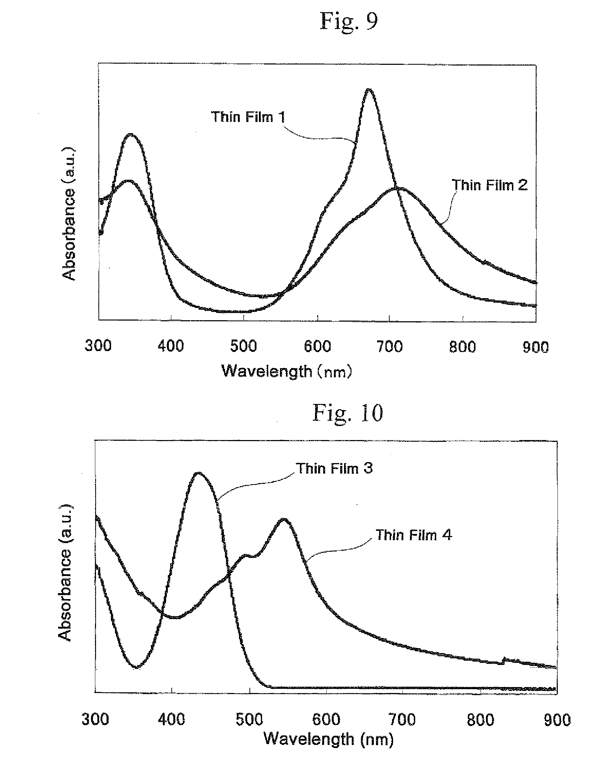

Further, an absorption spectrum of the thus-produced film was measured. The absorption spectrum was measured using an ultraviolet-visible spectrometer MPC-2200/UV-2400 (trade name, manufactured by Shimadzu Corporation). The measurement result is shown in Fig. 9. The absorption spectrum of the thin film 1 is shown in Fig. 9. Since the shape of the absorption spectrum was similar to the absorption spectrum (not shown) of the dye precursor-containing coating liquid, it was found that the solvent-soluble precursor compound did not change in the film, and there was almost no interaction between molecules (λₘₐₓ=673 nm).

### (Production of Thin Film 2)

Then, the thin film 1 was subjected to a heat treatment at 350 °C for 3 minutes in an atmosphere. Thereafter, an absorption spectrum of the film was measured in the same manner as described above. The measurement result is shown in Fig. 9. The absorption spectra of the thin film 1 and thin film 2 are shown in Fig. 9. It was found that the compound was desubstituted by heating, and, as a result, interaction between molecules in the film increased (λₘₐₓ=709 nm). Further, in consideration of this result together with the result of the thin film 1, it is understood that the thin film 2 obtained by the above-described heat treatment was a film made of a solvent-insoluble phthalocyanine compound (cupper phthalocyanine (α-type)), which is a desired product in the present invention.

### <Comparative Example 1>

### (Production of Thin Film 3)

Thin film 3 was produced in the same manner as in Example 7, except that a compound described in Nature, Vol. 388, page 131 (1997) (the following Compound 1 for comparison) was used in place of the Exemplified compound (1) in Example 7.

An absorption spectrum of the thus-produced film was measured in the same manner as in Example 7. The measurement result is shown in Fig. 10. The absorption spectrum of the thin film 3 was as shown in the figure. Since the shape of the absorption spectrum was similar to the absorption spectrum of a solution of the following Compound 1 for comparison dissolved therein, it was found that the compound for comparison did not change in the film, and there was almost no interaction between molecules (λₘₐₓ=435 nm).

### Compound 1 for comparison

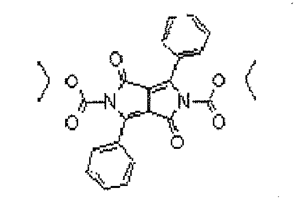

### (Production of Thin Film 4)

Then, the thin film 3 was subjected to a heat treatment at 180 °C for 3 minutes in an atmosphere. Thereafter, an absorption spectrum of the film was measured in the same manner as described above. The absorption spectrum of the thin film 4 was as shown in the figure, and it was found that the substituent (Boc group) was desubstituted from the compound by the heat treatment, and, as a result, a diketopyrrolopyrrol compound pigment was produced, and further, an interaction between the pigment molecules in the film increased (λₘₐₓ=546 nm).

### Light Fastness Evaluation

### <Light Resistance Evaluation of Dye Film>

The above-described thin films 1 to 4 were each stored for 24 hours under the conditions of 23 °C and 50% RH. Thereafter, these thin films were each subjected to a light resistance test using a merry-go-round type apparatus for testing of light resistance (Cell Testing Apparatus III, trade name, manufactured by Eagle Engineering Co., Ltd., with a filter WG 320, trade name, manufactured by Schott AG). Absorption spectra of the dye films just before the light resistance test and the dye films after the light resistance test for 48 hours were measured using UV-1600 PC (trade name, manufactured by Shimadzu Corporation). A change of absorbance at the maximum absorption wavelength was read from each absorption spectrum. The results are shown in Table 6.

**Table 6**

| Sample | Heat treatment | Compound | Residual rate after 48 houts |
|---|---|---|---|
| Thin Film 1 | Before heating | Exemplified compound (1) | 82% |
| Thin Film 2 | After heating | Exemplified compound (1) | 93% |
| Thin Film 3 | Before heating | Compound 1 for comparison | 1.9% |
| Thin Film 4 | After heating | Compound 1 for comparison | 91% |

As is apparent from the results shown in Table 6, dye films showing high light fastness were obtained as a result of desubstitution from each of Exemplified compound (1) and Compound 1 for comparison caused by the heat treatment. However, Compound 1 for comparison having a Boc group before the heat treatment was very inferior in terms of light fastness. In contrast, Exemplified compound (1) for use in the first embodiment of the present invention showed excellent light fastness even before the heat treatment. From these results, it is understood that according to the first embodiment of the present invention, the compounds before and after desubstitution, namely each of the solvent-soluble precursor compound and the solvent-insoluble compound obtained therefrom, each shows significantly excellent storage stability.

### <Comparative Example 2>

According to an acid pasting method, α-type cupper phthalocyanine fine crystals were obtained using cupper phthalocyanine β-type, manufactured by Tokyo Chemical Industry Co, Ltd.) in place of the Exemplified compound (1). Specifically, 2.5 g of cupper phthalocyanine β-type, manufactured by Tokyo Chemical Industry Co, Ltd.) was dissolved in 25 ml of concentrated sulfuric acid and then poured into 500 ml of water at 0 °C, to obtain the α-type fine crystals.

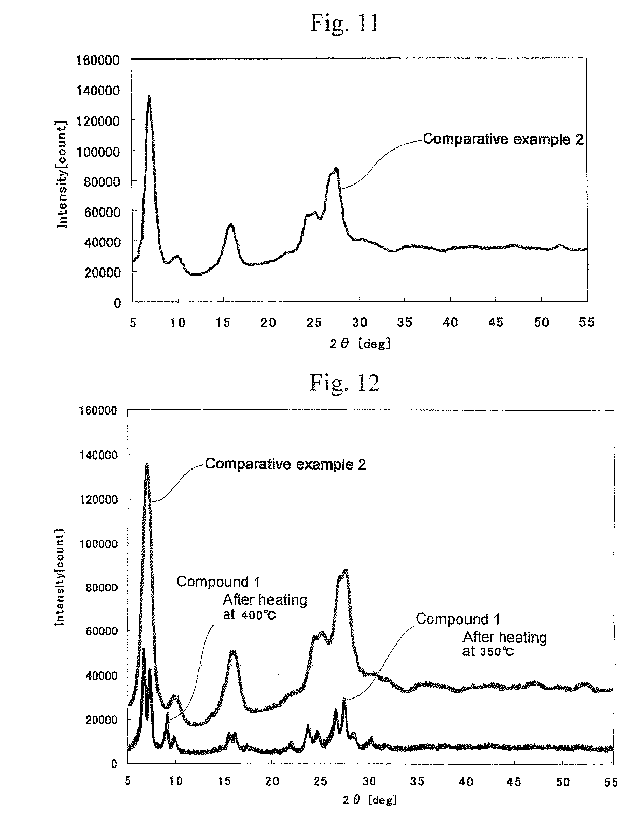

The thus-obtained α-type fine crystals were subjected to a X-ray diffraction measurement. For X-ray diffraction measurement, X-RAY DIFFRACTOMETER RINT-2500 (trade name, manufactured by Rigaku Corporation) was used. The results are shown in Fig. 11. Further, the data of α-type crystals (those heated at 350 °C or 400 °C) in Fig. 3 among results of X-ray diffraction measurement in Example 1 as against the chart in Fig. 11 showing the results of X-ray diffraction measurement in Comparative Example 2 are shown in Fig, 12.

As is apparent from the results shown in these figures, each of the compounds obtained in Example 1 and Comparative Example 2 showed a peak of α-type cupper phthalocyanine crystalline structure. However, a half-width value of the crystal obtained in Example 1 was narrower than that of the crystal obtained in Comparative Example 2. From these results, it is understood that the first embodiment of the present invention makes it possible to produce α-type crystals comprised of a large-size crystallite, even though it is generally difficult to form a large-size crystallite in the case of the metastable α-type crystal.

### <Comparative Example 3>

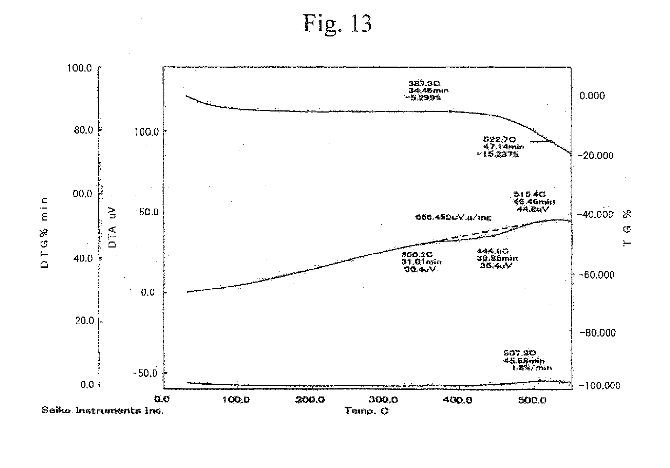

The results of TG/DTA measurement of copper phthalocyanine-tetrasulfonic acid tetrasodium salt commercially available from Aldolich Chemical are shown below. This compound (2) for comparison was soluble in water. The results of TG measurement of the compound are shown in Fig. 13. It is considered that the initial reduction in weight in TG arises from a solvent or water. Thereafter, even though the compound was heated up to 400 °C, the compound did not cause any reduction in weight. From that result, it is understood that, for the desubstitution of the substituent (sodium sulfonate) from the copper phthalocyanine-tetrasulfonic acid tetrasodium salt, a temperature higher than 400 °C is necessary.

### Example 2-1

### (Production of Thin Film Sample for Absorption Spectrum Measurement and Sample for FET Characteristics Measurement)

Compound 1a (1 mg) was dissolved in chloroform (1 ml), and the resultant solution was cast on a quartz substrate, to obtain a thin film sample for absorption-spectrum measurement, having a uniform thickness of 1 µm or less.

Similarly, a thin film sample for FET-characteristics measurement, having uniform thickness of 1 µm or less was obtained by casting the above-described solution on a substrate for measurement of FET characteristics. A substrate having a bottom contact-type construction shown in Fig. 15-1 was used as the substrate for measurement of FET characteristics. Specifically, a silicon substrate was used which had a bottom contact-type construction provided with chromium/gold electrodes (gate width W=100,000 µm, gate length L=100 µm) disposed in a comb-shape as a source electrode and a drain electrode and SiO₂ as an insulation film.

### (Measurement of FET Characteristics)

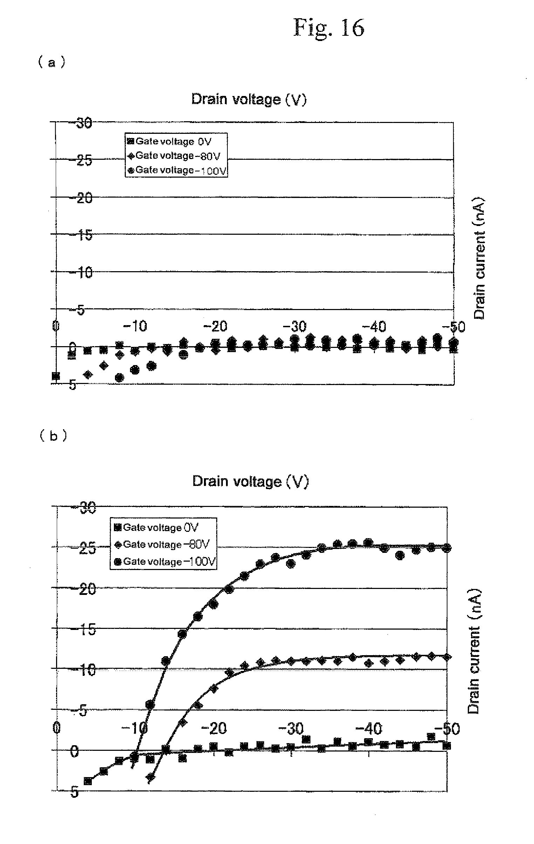

First, with respect to the sample for FET characteristics measurement, the FET characteristics (drain voltage-drain current property at the time when 100 V of gate voltage is impressed) was measured. The FET characteristics was measured at normal pressure and in a nitrogen atmosphere using a semiconductor parameter analyzer 4156C (trade name, manufactured by Agilent Technologies) connected with a semi-auto prober AX-2000 (trade name, manufactured by Vector Semiconductor CO., LTD.). The measurement results are shown in Fig. 16(a).

As is apparent from Fig. 16(a), the sample before a heat treatment did not exhibit any FET characteristics. The organic film produced at this point was observed under a polarizing microscope and an electronic microscope, and formation, of a uniform amorphous film was confirmed.

Then, the sample for FET characteristics measurement was subjected to a heat treatment at 300 °C for 5 minutes in a nitrogen atmosphere, and then the FET characteristics was measured. The measurement results are shown in Fig. 16(b).

As is apparent from Fig. 16(b), the sample after the heat treatment showed good p-type semiconductor characteristics. A carrier mobility µ was calculated using formula I_{d} that represents a drain current: I_{d} = (W/2L) µ C_{¡} (V_{g}-Vₜₕ)², in which L represents a gate length, W represents a gate width, Cᵢ represents a content of the insulating layer per unit area, Vg represents a gate voltage, and Vₜₕ represents a threshold voltage. The calculated carrier mobility µ was 3.1 x 10⁻⁵ cm²/Vs. Further, an on/off ratio was calculated from the ratio of the maximum drain current and the minimum drain current (I_{d}) with respect to the gate voltage-drain current property at the time when -100 V of drain voltage is impressed. The calculated on/off ratio was 5 x 10² (at the time when -100 V of gate voltage was impressed). After leaving the above-described sample for one month in the atmosphere, the same measurement as described above was conducted. As a result, it was found that a deviation of mobility was within 5% and hence this sample had high stability in the atmosphere.

### (Measurement of Absorption Spectrum)

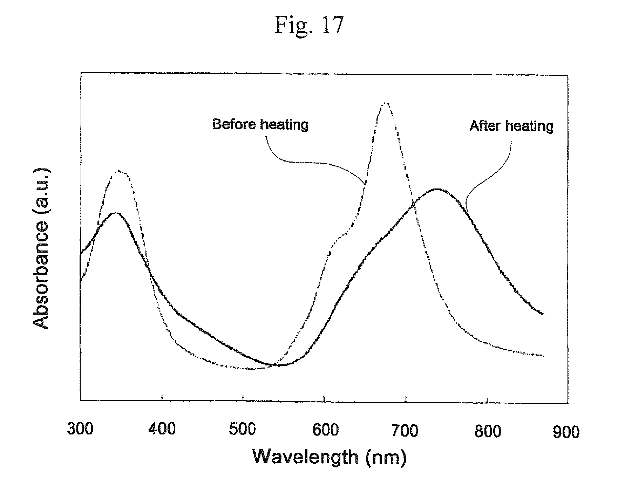

First, absorption spectrum of the above-described thin film sample for absorption spectrum measurement was measured. The absorption spectrum was measured using an ultraviolet-visible spectrometer MPC-2200/UV-2400 (trade name, manufactured by Shimadzu Corporation). Then, the sample was subjected to a thermal treatment at 300°C for 5 min in a nitrogen atmosphere, and then the absorption spectrum was measured in the same manner as described above. The measurement results are shown in Fig. 17.

As is apparent from Fig. 17, it is understood that since the spectrum shape of the sample before the heat treatment was similar to that of a solution thereof, and there was almost no intermolecular interaction between molecules in the film (λₘₐₓ=675 nm). In contrast, with respect to the sample after the heat treatment, it is understood that intermolecular interaction between molecules in the film increased as a result of desubstitution by the heat treatment (λₘₐₓ=742 nm).

### Example 2-2

FET characteristics were evaluated in the same manner as in Example 2-1, except for using Compound 1b in place of Compound 1a. As a result, similarly to Compound 1a, Compound 1b before the thermal treatment showed no FET characteristics, but after the heat treatment, the Compound 1b showed good p-type semiconductor properties. The mobility was 4.0 x 10⁻⁷ cm²/Vs.

### Example 2-3

FET characteristics were evaluated in the same manner as in Example 2-1, except for using Compound 1c in place of Compound 1a. As a result, similarly to Compound 1a, Compound 1c before the thermal treatment showed no FET characteristics, but after the heat treatment, the Compound 1c showed good p-type semiconductor properties. The mobility was 9.1 x 10⁻⁶ cm²/Vs.

### Example 2-4

FET characteristics were evaluated in the same manner as in Example 2-1, except for using, as a coating liquid, 1 ml of pure water solution of Compound 7a in place of the 1 ml of chloroform solution of Compound 1a (1 mL). As a result, similarly to Compound 1a, Compound 7a before the heat treatment showed no FET characteristics, but after the heat treatment, Compound 7a showed good p-type semiconductor properties. The mobility was 1.1 x 10⁻⁷ cm²/Vs.

### Example 2-5

FET characteristics were evaluated in the same manner as in Example 2-1, except for using, as a coating liquid, 1 ml of pure water solution of Compound 7b in place of the 1 ml of chloroform solution of Compound 1a (1 mL). As a result, similarly to Compound 1a, Compound 7b before the heat treatment showed no FET characteristics, but after the heat treatment, Compound 7b showed good p-type semiconductor properties. The mobility was 2.7 x 10⁻⁶ cm²/Vs.

### Comparative Example 2-1

Sample for FET characteristics measurement was produced in the same manner as in Example 2-1, except for using cupper phthalocyanine (CuPc: C₃₂H₁₆N₅Cu, a commercial product bought from Tokyo Chemical Industry Co, Ltd. and was subjected to sublimation purification) in place of Compound 1 a.

FET characteristics of thus-produced sample were measured in the same manner as in Example 2-1, but the sample showed no FET characteristics. Further, after the heat treatment was performed in the same manner as in Example 2-1, FET characteristics were measured, but the sample still showed no FET characteristics.

The device used in these measurements was observed under a polarizing microscope and an electronic microscope. As a result, it was found that the solubility of the cupper phthalocyanine with respect to chloroform was so low that a film was not formed.

### Comparative Example 2-2

Sample for FET characteristics measurement was produced in the same manner as in Example 2-2, except for using zinc phthalocyanine (ZnPc: C₃₂H₁₆N₈Zn, a commercial product bought from Tokyo Chemical Industry Co, Ltd. and was subjected to sublimation purification) in place of Compound 1b.

FET characteristics of thus-produced sample were measured in the same manner as in Example 2-1, but the sample showed no FET characteristics. Further, after the heat treatment was performed in the same manner as in Example 2-2, FET characteristics were measured, but the sample still showed no FET characteristics.

The device used in these measurements was observed under a polarizing microscope and an electronic microscope. As a result, it was found that the solubility of the zinc phthalocyanine with respect to chloroform was so low that a film was not formed.

### Comparative Example 2-3

Sample for FET characteristics measurement was produced in the same manner as in Example 2-3, except for using metal-free phthalocyanine (H₂Pc: C₃₂H₂₀N₈, a commercial product bought from Tokyo Chemical Industry Co, Ltd. and was subjected to sublimation purification) in place of Compound 1 c.

FET characteristics of thus-produced sample were measured in the same manner as in Example 2-1, but the sample showed no FET characteristics. Further, after the heat treatment was performed in the same manner as in Example 2-3, FET characteristics were measured, but the sample still showed no FET characteristics.

The device used in these measurements was observed under a polarizing microscope and an electronic microscope. As a result, it was found that the solubility of the metal-free phthalocyanine with respect to chloroform was so low that a film was not formed.

### Comparative Example 2-4

Sample for FET characteristics measurement was produced in the same manner as in Example 2-4, except for using zinc phthalocyanine (ZnPc,: C₃₂H₁₆N₈Zn, a commercial product bought from Tokyo Chemical Industry Co, Ltd. and was subjected to sublimation purification) in place of Compound 7a.

FET characteristics of thus-produced sample were measured in the same manner as in Example 2-1, but the sample showed no FET characteristics. Further, after the heat treatment was performed in the same manner as in Example 2-2, FET characteristics were measured, but the sample still showed no FET characteristics.

The device used in these measurements was observed under a polarizing microscope and an electronic microscope. As a result, it was found that the solubility of the zinc phthalocyanine with respect to water was so low that a film was not formed.

### Comparative Example 2-5

Sample for FET characteristics measurement was produced in the same manner as in Example 2-5, except for using metal-free phthalocyanine (H₂Pc: C₃₂H₂₀N₈, a commercial product bought from Tokyo Chemical Industry Co, Ltd. and was subjected to sublimation purification) in place of Compound 7b.

FET characteristics of thus-produced sample were measured in the same manner as in Example 2-1, but the sample showed no FET characteristics. Further, after the heat treatment was performed in the same manner as in Example 2-3, FET characteristics were measured, but the sample still showed no FET characteristics.

The device used in these measurements was observed under a polarizing microscope and an electronic microscope. As a result, it was found that the solubility of the metal-free phthalocyanine with respect to water was so low that a film was not formed.

### Example 2-6

A glass substrate (2.5 cm x 2.5 cm) having a patterned ITO electrode thereon was subjected to an ultrasonic cleaning in isopropyl alcohol, and then dried. Further, the glass substrate was subjected to UV ozone processing for 30 minutes, to remove organic contaminants on the surface of the ITO electrode. Then, an aqueous solution of PEDOT (poly(3,4-ethylenedioxythiophene))/PSS (polystylenesulfonic acid) (Baytron P (standard goods)) was spin-coated (4,000 rpm, 60 seconds) on the ITO substrate and then dried at 120 °C for 10 minutes, to form a hole transporting buffer layer of film thickness about 50 nm. The film thickness was measured using a stylus film thickness meter DEKTAK 6M (trade name, manufactured by Ulvac, Inc.) (hereinafter, same as above). Then, a mixed solution of Compound 1a and PCBM ([6,6]-phenyl-C₆₁-methyl butyrate ester) dissolved in chloroform. {(15 mg + 15 mg)/ml} was spin-coated at 1,000 rpm on the buffer layer, to form an organic semiconductor (organic photoelectric conversion layer) precursor film having an almost uniform thickness of 200 nm or less. The thus-formed organic semiconductor precursor film was heated up to 400 °C at the rate of 10 °C/min and then kept at 400 °C for 5 minutes, to convert to an organic semiconductor film. In this manner, a photoelectric conversion layer was formed. On the photoelectric conversion layer, about 1 nm of LiF as a buffer layer and about 80 nm of aluminum as a metal electrode were sequentially vacuum-deposited in this order at the degree of vacuum of 2 x 10⁻⁴ or less using a vacuum deposition equipment EBX-8C (trade name, manufactured by Ulvac, Inc.), to obtain an organic photoelectric conversion device having an effective area of 0.04 cm².

The thus-obtained device was irradiated with artificial-sunlight having AM 1.5 and 100 mW/cm² using a solar simulator (150W Low-Cost Solar Simulator, manufactured by Oriel). Then, current-voltage characteristics were measured using an electrochemical analyzer ALS Model-660B (trade name, manufactured by BAS Inc.). As a result, it was found that both photocurrent and photovoltaic power were caused and good photoelectric conversion properties were obtained. The photovoltaic power was 0.40 V.

### Comparative Example 2-6

An organic photoelectric conversion device was produced in the same manner as in Example 2-6, except for using cupper phthalocyanine (CuPc: C₃₂H₁₆N₈Cu, a commercial product bought from Tokyo Chemical Industry Co, Ltd. and was subjected to sublimation purification) in place of Compound 1a.

The photoelectric conversion properties of the thus-produced sample were measured in the same manner as in Example 2-6. However, the sample showed no photoelectric conversion properties.

The device used in this measurement was observed under a polarizing microscope and an electronic microscope. As a result, it was found that solubility of the cupper phthalocyanine with respect to chloroform was so low that a film was not formed.

Having described our invention as related to the present embodiments, it is our intention that the invention not be limited by any of the details of the description, unless otherwise specified, but rather be construed broadly within its spirit and scope as set out in the accompanying claims.

This application claims priority under on Patent Application No. 2007-237313 filed in Japan on September 12, 2007, and Patent Application No. 2007-237315 filed in Japan on September 12, 2007, each of which is entirely herein incorporated by reference.

## Claims

1. A method of producing a desubstituted compound, comprising:
applying an external stimulation to a compound A-(B)ₘ which has a solvent-soluble group B, to cause desubstitution of the solvent-soluble group B from the compound, wherein A represents a residue of a solvent-insoluble compound, the solvent-soluble group B is represented by formula (I), and m represents a natural number, in which the solvent-soluble group B bonds to a carbon atom of the residue A of a solvent-insoluble compound; and
converting the compound A-(B)ₘ to a solvent-insoluble compound to which a hydrogen atom bonds in place of the solvent-soluble group B:
Formula (I) -S(O)n**-**X
wherein X represents a hydrogen atom or a substituent; and n represents an integer of 1 or 2.

2. The method of producing a desubstituted compound as claimed in claim 1, wherein the external stimulation is conducted by heating at 150 to 500 °C.

3. The method of producing a desubstituted compound as claimed in claim 1 or 2, wherein the residue A of a solvent-insoluble compound is a residue of a π-conjugated compound having a structure in which two or more aromatic hydrocarbon rings or aromatic hetero rings are condensed and/or linked via a covalent bond.

4. The method of producing a desubstituted compound as claimed in any one of claims 1 to 3, wherein the residue A of a solvent-insoluble compound is a dye skeleton.

5. The method of producing a desubstituted compound as claimed in any one of claims 1 to 4, wherein the solvent-soluble group B is a group represented by formula (II): 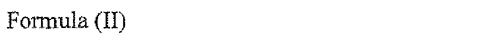 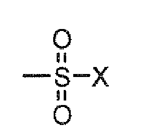 wherein X represents a hydrogen atom or a substituent.

6. The method of producing a desubstituted compound as claimed in any one of claims 1 to 5, wherein the solvent-soluble group B is a group represented by formula (III): 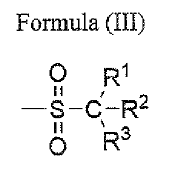 wherein R¹ to R³ each independently represent a hydrogen atom or a substituent.

7. The method of producing a desubstituted compound as claimed in any one of claims 1 to 6, wherein the compound A-(B)ₘ is a compound represented by formula (IV): 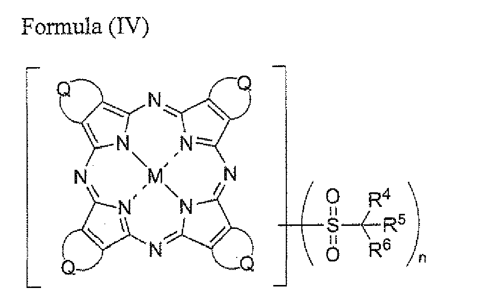 wherein M represents a metal atom or hydrogen atoms; when M represents hydrogen atoms, two hydrogen atoms bond to any two nitrogen atoms of N¹ to N⁴, separately; Q represents a group of atoms necessary to form an aromatic hydrocarbon ring or an aromatic hetero ring; a plurality of Qs may be the same or different from each other; R⁴ to R⁶ each independently represents a hydrogen atom or a substituent; n is a natural number; and when n is 2 or more, a plurality of the -SO₂C(R⁴)(R⁵)(R⁶) groups may be the same or different from each other.

8. The method of producing a desubstituted compound as claimed in claim 7, wherein the compound A-(B)ₘ is a phthalocyanine compound.

9. A method of producing pigment fine-particles, comprising:
applying an external stimulation to a pigment precursor A-(B)ₘ of a structure in which a pigment is modified with a solvent-soluble group B, to cause desubstitution of the solvent-soluble group B from the pigment precursor, wherein A represents a residue of a pigment, the solvent-soluble group B is represented by formula (I), and m represents a natural number, in which the solvent-soluble group B bonds to a carbon atom of the residue A of a pigment; and
converting the pigment precursor to a pigment to which a hydrogen atom bonds in place of the solvent-soluble group B:
Formula (I) -S(O)n-X
wherein X represents a hydrogen atom or a substituent; and n represents an integer of 1 or 2.

10. A method of producing a phthalocyanine compound, comprising:
applying an external stimulation to a phthalocyanine compound having a substituent represented by formula (I), thereby causing desubstitution of the substituent from the phthalocyanine compound, wherein the substituent binds to a carbon atom of a residue of the phthalocyanine compound; and
converting the phthalocyanine compound having the substituent to a phthalocyanine compound to which a hydrogen atom bonds in place of the substituent:
Formula (I) -S(O)n -X
wherein X represents a hydrogen atom or a substituent; and n represents an integer of 1 or 2.

11. A method of producing a thin film, comprising:
dissolving a compound A-(B)ₘ which has a solvent-soluble group B, in a solvent, to give a solution, wherein A represents a residue of a solvent-insoluble compound, the solvent-soluble group B is represented by formula (I), and m represents a natural number, in which the solvent-soluble group B bonds to a carbon atom of the residue A of a solvent-insoluble compound;
coating a substrate with the solution, to form a coated film;
applying an external stimulation to the compound A-(B)ₘ in the coated film, to cause desubstitution of the solvent-soluble group B from the compound; and
converting the compound A-(B)ₘ to a solvent-insoluble compound to which a hydrogen atom bonds in place of the solvent-soluble group B, thereby forming a thin film of the solvent-insoluble compound:
Formula (I) -S(O)n-X
wherein X represents a hydrogen atom or a substituent; and n represents an integer of 1 or 2.

12. A method of producing an organic semiconductor film, comprising the steps of:
forming a film of a π-conjugated compound having a substituent represented by formula (2-1), on a substrate; and
causing desubstitution, of the substituent from the compound: 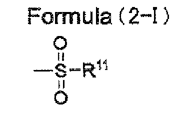 wherein R¹¹ represents a substituent other than a hydrogen atom.

13. The method of producing an organic semiconductor film as claimed in claim 12, wherein the compound is a compound represented by formula (2-II): 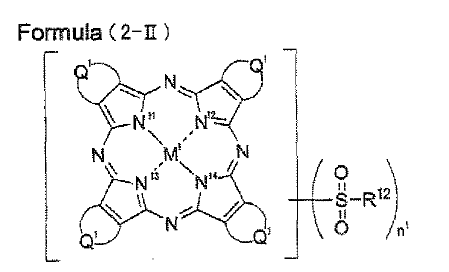 wherein M¹ represents a metal atom or hydrogen atoms; when M¹ represents hydrogen atoms, two hydrogen atoms bond to any two nitrogen atoms of N¹¹ to N¹⁴, separately; Q¹ represents a group of atoms necessary to form an aromatic hydrocarbon ring or an aromatic hetero ring; a plurality of Q¹ s may be the same or different from each other; R¹² represents a substituent other than a hydrogen atom; n¹ is a natural number; and when n¹ is 2 or more, a plurality of the -SO₂R¹² groups may be the same or different from each other.

14. The method of producing an organic semiconductor film as claimed in claim 13, wherein the compound is a phthalocyanine compound.

15. The method of producing an organic semiconductor film as claimed in any one of claims 12 to 14, wherein the step of forming the film of the compound on the substrate is a step of forming the film, by dissolving the compound in a solvent, to give a solution, coating the substrate with the solution, and drying.

16. The method of producing an organic semiconductor film as claimed in any one of claims 12 to 15, wherein the step of causing desubstitution of the substituent is conducted by heating.

17. An organic semiconductor film obtained by the method as claimed in any one of claims 12 to 16.

18. An organic electronic device, comprising the organic semiconductor film as claimed in claim 17.

19. An organic field-effect transistor, comprising the organic semiconductor film as claimed in claim 17.

20. An organic photoelectric conversion device, comprising the organic semiconductor film as claimed in claim 17.
